## Europäisches Patentamt
## European Patent Office
## Office européen des brevets

(19)

(11)  **EP 0 753 082 B1**

(12)  **EUROPÄISCHE PATENTSCHRIFT**

(45) Veröffentlichungstag und Bekanntmachung des Hinweises auf die Patenterteilung:
**07.07.1999 Patentblatt 1999/27**

(21) Anmeldenummer: **95914322.3**

(22) Anmeldetag: **29.03.1995**

(51) Int Cl.⁶: **C23C 16/52**, C23C 16/50, C23C 16/44

(86) Internationale Anmeldenummer:
**PCT/EP95/01168**

(87) Internationale Veröffentlichungsnummer:
**WO 95/26427 (05.10.1995 Gazette 1995/42)**

(54) **PCVD-VERFAHREN UND VORRICHTUNG ZUR BESCHICHTUNG VON GEWÖLBTEN SUBSTRATEN**

PCVD PROCESS AND DEVICE FOR COATING DOMED SUBSTRATES

PROCEDE PLASMA-CVD DE REVETEMENT DE SUBSTRATS BOMBES

(84) Benannte Vertragsstaaten:
**AT CH DE ES GB LI SE**

(30) Priorität: **29.03.1994 DE 4410841**

(43) Veröffentlichungstag der Anmeldung:
**15.01.1997 Patentblatt 1997/03**

(73) Patentinhaber:
- **Schott Glas**
  **55122 Mainz (DE)**
  Benannte Vertragsstaaten:
  **CH DE ES LI SE AT**
- **Carl Zeiss Stiftung Trading as Schott Glaswerke**
  **55122 Mainz (DE)**
  Benannte Vertragsstaaten:
  **GB**

(72) Erfinder:
- **HEMING, Martin**
  **D-55442 Stromberg (DE)**
- **LANGE, Ulrich**
  **D-55411 Bingen (DE)**
- **LANGFELD, Roland**
  **D-60489 Frankturt (DE)**

- **MÖHL, Wolfgang**
  **D-67550 Worms (DE)**
- **OTTO, Jürgen**
  **D-55128 Mainz (DE)**
- **PAQUET, Volker**
  **D-55126 Mainz (DE)**
- **SEGNER, Johannes**
  **D-55442 Stromberg (DE)**
- **WALTHER, Marten**
  **D-55270 Bubenheim (DE)**

(74) Vertreter: **Fuchs Mehler Weiss & Fritzsche Patentanwälte**
**Abraham-Lincoln-Strasse 7**
**65189 Wiesbaden (DE)**

(56) Entgegenhaltungen:
DE-A- 3 322 680          DE-C- 4 137 606
DE-U- 8 313 563          US-A- 4 500 563
US-A- 4 935 661          US-A- 5 272 360

- PATENT ABSTRACTS OF JAPAN vol. 017 no. 110 (E-1329) ,8.März 1993 & JP,A,04 293235 (KOKUSAI ELECTRIC CO LTD) 16.Oktober 1992,

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

## Beschreibung

Die Erfindung betrifft ein Verfahren zur Ermittlung von Prozeßparametern für ein PICVD-Verfahren zur Herstellung von Beschichtungen gleichmäßiger Schichtdicke auf gewölbten Substraten, insbesondere auf Linsen aus Glas oder Kunststoff, bei dem die zu beschichtende Substratoberfläche gegenüber den Gasdurchlaßflächen einer Gasdusche angeordnet wird, durch welche schichtbildende Gase enthaltende Gasmischungen in eine Reaktionskammer strömen, wo durch zeitliche Impulspausen getrennte Plasmaimpulse erzeugt werden. Die Erfindung betrifft auch das Herstellungsverfahren sowie eine Plasma-CVD-Vorrichtung gemäß dem Oberbegriff des Patentanspruchs 13.

Aus der DE 40 08 405 C1 ist ein Mikrowellen-PICVD-Verfahren zur Herstellung eines Kaltlichtspiegels auf der Innenseite von kalottenförmigen Substraten bekannt, die auch aus Kunststoff sein können. Zur Erreichung einer gleichmäßigen Schichtdicke wird u.a. eine der Kontur der Oberfläche angepaßte Gasdusche empfohlen. Das bekannte Verfahren gibt zwar prinzipiell einen Hinweis, wie ein gewölbtes Substrat gleichmäßig dick beschichtet werden kann. Sind jedoch Substrate mit unterschiedlichen Oberflächenkrümmungen zu beschichten - bei Brillengläsern gibt es beispielsweise mehr als 10 000 unterschiedliche Formen -, dann ist dieses Verfahren aus wirtschaftlichen Gründen wegen der Vielzahl erforderlicher Gasduschenköpfe nicht anwendbar.

Die FR 26 77 841 beschreibt einen Mikrowellenplasma-CVD-Reaktor zur Herstellung von Schutz- und Filterschichten auf optischen Kunststoffsubstraten, wie z.B. Linsen. Das Substrat liegt auf der Elektrode eines 13,56-MHz-Generators auf und wird auf eine Bias-Spannung gebracht wird. Sauerstoff wird durch ein 2,45-Gigahertz-Mikrowellenfeld angeregt, das seinerseits durch Stoß einen entfernt einströmenden siliziumhaltigen Reaktionspartner anregt, so daß sich auf dem Substrat eine Schicht bildet. Die Rückseite des Substrates wird durch einen an die Form angepaßten Gegenkörper vor unerwünschter Beschichtung bewahrt, so daß dieses Verfahren bei Substraten mit unterschiedlichen Oberflächenkrümmungen wegen der Vielzahl der erforderlichen Gegenkörper unwirtschaftlich ist. Über erzielbare Gleichmäßigkeiten wird keine Aussage gemacht.

Die DE 41 42 877 A1 beschreibt ein CVD-Verfahren und eine Vorrichtung zur gleichmäßig dicken Beschichtung von Halbleiterwafern, wobei die Gleichmäßigkeit dadurch erzielt wird, daß eine Gasdusche verwendet wird, die mehrere voneinander getrennte Gaseinblasgebiete aufweist. Die Gasdusche ist gegenüber dem Substrat angeordnet und von einer Abzugshaube umgeben, die rotationssymmetrisch zum Substrat das Beschichtungsgas absaugt. Das erste und zweite Gaseinblasgebiet muß in einer gemeinsamen Ebene angeordnet sein, damit sich eine Schicht hoher Qualität und gleichmäßiger Dichte bilden kann. Es ist daher nicht zu erwarten, daß dieses Verfahren zur uniformen Beschichtung gekrümmter Oberflächen einsetzbar ist. Ein weiterer Nachteil dieser bekannten Vorrichtung besteht darin, daß das Beschichtungsverfahren relativ langsam abläuft und daß nur eine geringe Gleichmäßigkeit der Beschichtung von etwa ± 5% erreicht wird, die zur Herstellung von Antireflexbeschichtungen nicht ausreichend ist. Darüber hinaus gibt es keine Hinweise zur Beschichtung von gewölbten Substraten mit und ohne Rotationssymmetrie, noch werden Maßnahmen erwähnt, wie die Rückseite solcher Substrate vom Beschichtungsprozeß unbeeinflußt gehalten werden kann.

Die DE 39 31 713 C1 beschreibt ein Verfahren und eine Vorrichtung für die gleichzeitige und allseitige CVD-Beschichtung von gekrümmten Substraten in einem 13,56 Megahertz-Plasma. Es wird angegeben, daß ein krümmungsbedingter Schichtdickenunterschied vom Zentrumsbereich der Linse zu deren Peripherie nicht festgestellt werden konnte. Allerdings wird nicht angegeben, welche Meßgenauigkeit zugrunde gelegt wurde. Das Verfahren bezieht sich allein auf die Abscheidung von Kratzschutzsichten, für welche die Anforderungen an die Uniformität wesentlich geringer sind als für die Abscheidung von Anti-Reflex-Schichten. Die Eignung dieses Verfahrens zur Herstellung von Antireflexionsschichten ist nicht bekannt.

Die DE 34 13 019 A1 beschreibt ein Plasma-CVD-Verfahren zur Herstellung einer transparenten kratzbeständigen Schicht auf transparenten Kunststoffelementen durch Polymerisation von HMDSO oder anderer Siorganischer Verbindungen, wobei durch einen stufenlosen Übergang von einem organischen Polymer zu einer anorganisch harten Deckschicht eine gute Haftung auf dem Substrat bei gleichzeitiger großer Oberflächenhärte erreicht wird. Die Vorrichtung weist einen Vakuumrezipienten auf, in dem sich eine um ihre Achse drehbare Trommel befindet, auf deren Umfangsfläche die zu beschichtenden Kunststoffteile angebracht sind. Die Beschichtungsteile passieren zeitlich hintereinander eine Beschichtungseinheit, die aus einer Vielzahl von Einzeldüsen besteht, in die Reaktionsgase eingeleitet werden. Durch eine von außen angelegte Hochspannung wird in dem ausströmenden Monomerdampf eine Glimmentladung gezündet. Mit diesem Verfahren ist jedoch die Herstellung einer Kratzschutzbeschichtung möglich.

Klug, Schneider und Zöller beschreiben in SPIE Vol. 1323 Optical Thin-Films III: New Developments 1990 (Seite 88ff) ein Verfahren zum Aufbringen harter und dicker (2,5 bis 5 μm) Schutzschichten auf CR-39-Linsen durch Plasma-CVD-Verfahren mit den Gasen aus Sauerstoff- und Siliziumverbindungen und die anschließende Herstellung einer reflexmindernden Beschichtung mittels Hochvakuumbedampfung in einer weiteren Beschichtungsanlage.

Als Ausblick wird vorgeschlagen, nicht nur die Kratzschutzschicht, sondern auch die Antireflexbeschichtung mittels PCVD-Verfahren herzustellen. Es wird jedoch keine Lösung dafür angegeben, wie bei gekrümmten Substraten und der Anwendung desselben Verfahrens für beide Schichten die erforderliche Schichtdickengleichmäßigkeit erzielt werden kann, wobei insbesondere auch das Problem der Rückseitenbeschichtung nicht angegangen wird.

Die US 49 27 704 gibt ein Plasma-CVD-Verfahren zur Aufbringung einer transparenten Kratzschutzschicht auf Kunststoffen an, speziell Polycarbonat unter Verwendung von zwei Übergangsschichten, von denen eine einen kontinuierlichen Materialübergang von organisch zu anorganisch aufweist. Die Einstellung der Schichtdicke erfolgt über die Parameter Massenfluß der Beschichtungsgase, Substrattemperatur, Anregungsfrequenz und Druck. Die gewünschte Schichtdicke kann nur auf ±5% genau eingestellt werden und ist daher zur Herstellung von Antireflex-Schichten zu ungenau.

Aus der EP 0 502 385 ist ein Verfahren zur Herstellung einer doppelseitigen Beschichtung von optischen Werkstücken bekannt. Die Bedampfung der Werkstücke erfolgt mit Hilfe von Verdampfungsquellen, welche in einem gewissen Abstand gegenüber der Werkstückhalterung angeordnet sind. Zur Herstellung von gleichförmigen Beschichtungen wird die Werkstückhalterung mit den Substraten während des Beschichtungsvorganges gedreht. Durch Drehen des Werkstückhalters zwischen den Elektroden hindurch wird sichergestellt, daß die der Bedampfung vorangehende oder nachfolgende Plasmaentladung, welche sich zwischen den Elektroden und dem als Gegenelektrode wirkenden Werkstückhalter ausbildet, gleichmäßig die Werkstücke überstreicht. Über die Güte der Beschichtung hinsichtlich der Dicke werden keine genauen Aussagen gemacht. Ein Nachteil besteht darin, daß beim Aufdampfvorgang ein Teil der Elektrode, welcher der Verdampfungsquelle ausgesetzt ist, mitbeschichtet wird. Das Beschichtungsmaterial, welches auf der Elektrode abgeschieden wird, wird somit den auf der Werkstückhalterung befindlichen Werkstücken verlorengehen. Das Plasma-CVD-Verfahren eignet sich offenbar nur zur Herstellung einer Kratzschutzschicht, weil für die Aufbringung der AR-Beschichtung ein Aufdampfverfahren eingesetzt werden muß, welches nicht gleichzeitig beide Oberflächen beschichten kann und das wegen Verwendung zweier Beschichtungsverfahren, insbesondere eines Hochvakuumverfahrens, wirtschaftlich ungünstig ist.

Die EP 0 550 058 A2 beschreibt eine Gaszonendusche für die Beschichtung von ebenen Werkstücken, wie Halbleiterwafern. Die einzelnen Zonen der Gasdusche können mit unterschiedlichen Massenflüssen und auch unterschiedlichen Gasen beaufschlagt werden. Über die Beschichtung von gewölbten Substraten wird jedoch keine Aussage gemacht.

Die US 4,991,542 beschreibt eine Anordnung zur beidseitigen, gleichzeitigen Beschichtung von ebenen Substraten mittels des Plasma-CVD-Verfahrens. In einer Reaktionskammer ist das zu beschichtende Substrat angeordnet, wobei den zu beschichtenden Seiten gegenüberliegend jeweils eine Gasdusche angeordnet ist, die gleichzeitig auch als Elektroden dienen. Eine Hochfrequenzspannung wird an das Substrat angelegt, so daß ein Plasma zwischen dem Substrat und den als Elektroden ausgebildeten Gasduschen erzeugt wird. Die Beschichtung von gekrümmten Substraten wird nicht erläutert.

In "M.Heming et al.: Plasma Impulse Chemical Vapor Deposition - a Novel Technique for Optical Coatings, in 5.Meeting Opt. Interference Coatings, Tuscon 1992" wird die Anwendung von Gasdusche und PICVD-Verfahren auf die gleichmäßige Beschichtung ebener Substrate beschrieben. Sollen nach dieser Methode gewölbte Substrate beschichtet werden, ohne die Gegenfläche (Gasdusche) an die Substratwölbung anzupassen, erwartet man deshalb eine Beschichtung, die umso ungleichmäßiger ist, je größer die Wölbung des Substrats ist.

Bei der Beschichtung von Substraten mit PICVD-Verfahren wird ein Gasraum über einem Substrat mit Schichtbildnermaterial gefüllt, welches in einem Plasmaimpuls zu Schichtmaterial umgesetzt wird. Die darauf folgende Impulspause wird so lange gewählt, daß ein kompletter Austausch durch Frischgas sichergestellt wird.

Bei der Anwendung von PICVD-Verfahren geht man davon aus, daß eine uniforme Beschichtung auf Substraten dann erzielt werden kann, wenn in erster Näherung die Produkte $K_i \times V_i$ für alle $V_i$ ungefähr konstant, oder, genauer, das Integral

$$F_i * \int_{h_i=0}^{h_i=h_L} K(h_i)dh_i \approx const$$

ist, wobei $K(h_i)$ die Konzentration an Schichtbildnergas in einem Abstand h vom Substrat, $F_i$ ein Flächenelement des Substrats und $h_L$ die Höhe des Gasvolumens ist, das zur Schichtbildung auf dem Substrat beiträgt, weil die Dicke der Beschichtung offensichtlich im wesentlichen von der Menge des schichtbildenden Materials im Volumenelement $V_i$ über dem zu beschichtenden Flächenelement abhängt.

Eine numerische Simulation der Strömung (Lösung der Navier-Stokes-Gleichung) und Schichtbildung, angewendet auf die PICVD-Beschichtung einer konvexen und konkaven Substratoberfläche bestätigt diese Erwartung:

Für eine PICVD-Beschichtung mit Mikrowellenanregung und üblichen Beschichtungsparametern und Verwendung einer Gasdusche und über der Gasdurchlaßfläche konstantem Massenfluß ergibt die Simulation der Her-

stellung einer $TiO_2$-Schicht aus einem $TiCl_4O_2$-Gasgemisch bei einem konvexen Krümmungsradius Ks=122 mm der Substratoberfläche eine Uniformität von nur U = 0,71. (U=Verhältnis von minimaler zu maximaler Schichtdicke); bei stärkerer Krümmung mit Ks = 80 ist die Uniformität sogar nur U = 0,6. Die Schichtdicke ist dabei am Rand des Substrats maximal und in der Mitte minimal. Bei konvexen Substraten stellt sich dann auch experimentell heraus, daß vermutlich aufgrund der höheren Gassäule über dem Substrat im Randbereich gegenüber der niedrigeren Gassäule in der Substratmitte auch die Schichtdicke im Randbereich entsprechend dicker war. Bei konkaven Substraten wurde ein entsprechend umgekehrter Schichtdickenverlauf festgestellt.

Die Druckschrift Patent Abstracts of Japan, vol. 17 no. 110 (E-1329), 08.03.93 & JP-A-293 235 offenbart eine Plasma-CVD-Vorrichtung mit einer Reaktionskammer, einer als Anode dienenden Substrathalterung mit zwei gegenüberliegend darauf angeordneten Substraten, sowie zwei mit Gaszuführeinrichtungen versehene und als planare Gasduschen ausgebildete Kathoden. Durch eine Einrichtung zur abwechselnden Beaufschlagung der beiden Kathoden mit gepulsten Hochfrequenz-Stromstößen wird dabei eine Interferenz der jeweiligen Plasmabereiche verhindert.

Aufgabe der Erfindung ist es, ein Verfahren zur Ermittlung der Prozeßparameter für ein PICVD-Verfahren zur Herstellung von Beschichtungen gleichmäßiger Schichtdicke auf gewölbten Substraten, ein Herstellungsverfahren und eine Vorrichtung bereitzustellen, mit denen gewölbte Substrate, wie z.B. Linsen und Brillengläser, in wirtschaftlicher Weise beschichtet werden können, wobei eine hohe Schichtdickengleichmäßigkeit erzielt werden soll.

Diese Aufgabe wird mit einem Verfahren gemäß den Merkmalen von Patentanspruch 1 gelöst. Ein Herstellungsverfahren ist Gegenstand des Patentanspruchs 9 und eine Vorrichtung ist Gegenstand des Patentanspruchs 13. Vorteilhafte Ausgestaltungen sind Gegenstand der Unteransprüche.

Es wurde nun überraschend gefunden, daß eine bessere Schichtdickengleichmäßigkeit dann erreicht werden kann, wenn man von der üblichen Vorgehensweise, nämlich die Impulspausen so lange zu wählen, daß die Reaktionskammer vor jedem neuen Impuls wieder vollständig mit Frischgas aufgefüllt ist, abweicht und die Impulspause stattdessen so weit verringert, daß kein vollständiger Gaswechsel mehr eintreten kann. Dies konnte sowohl für konvex als auch konkav gewölbte Substrate gezeigt werden und ist offensichtlich darauf zurückzuführen, daß bei Verkürzung der Impulspause beim Zünden des jeweils nächsten Impulses noch ein Restgasanteil des vorangegangenen Plasmaimpulses im Reaktionsraum verblieben ist, der sich mit dem zugeführten Frischgas mehr oder weniger vermischt hat. Offensichtlich erreicht bei ausreichend kurzer Impulspause die Frischgasfront noch nicht die Substratoberfläche an allen Stellen, so daß das Frischgasvolumen sich nicht in seiner Form der Substratoberfläche anpassen kann. Damit befinden sich dann aber zwischen Substratoberfläche und Gasduschenoberfläche unter jeder Flächeneinheit der Substratoberfläche annähernd gleich viele Schichtbildnermoleküle, so daß die Schichtdicke nicht meher durch die Höhe der Volumenelemente zwischen Substrat- und Gasduschenoberfläche bestimmt wird.

Dies gilt analog auch für konkav gewölbte Substrate.

Bei einer weiteren Verkürzung der Impulspause gelangen die Frischgase nicht mehr in ausreichender Menge bis zu den Bereichen des Substrates, die einen größeren Abstand zur Gasdusche aufweisen; es tritt zunehmend eine Verschlechterung der Schichtdickengleichmäßigkeit auf.

Es liegt auf der Hand, daß die obigen Ausführungen sinngemäß auch die Verhältnisse bei Annäherung an die optimale Impulspause von kleinen Impulspausen her beschreiben.

Basierend auf den obigen Erkenntnissen wurde ein Verfahren gefunden, mit dem die Prozeßparameter für die Beschichtung von gewölbten Substraten bestimmt werden können. Je nach Komplexität der Form der zu beschichtenden Linsenoberfläche kann folgendermaßen vorgegangen werden.


i. Linsen mit schwacher Wölbung


Bei Oberflächen mit schwacher Wölbung, die annähernd durch das Verhältnis Scheitelhöhe zu Linsendurchmesser zwischen -0,07 und +0,07 festgelegt sind (-:=konkav) kann mit einer konventionell eingestellten planaren Gasdusche gearbeitet werden. Eine konventionelle Gasdusche zeichnet sich dadurch aus, daß die Gasmassenflußdichten durch alle Durchlaßöffnungen gleich sind. Man stellt dann den Massenfluß der Prozeßgasmischung auf einen Wert ein, der vorzugsweise zwischen $0.8{*}r^2$ und $80{*}r^2$ (sccm) liegt, wobei r der in cm gemessene Linsenradius ist. Als Startwert für die Impulspause kann entweder ein kleiner Wert (zwischen 0,1 und 2 ms) oder alternativ ein großer Wert (typisch 500 ms) gewählt werden. Die Impulspause wird dann vergrößert bzw. verkleinert bis eine optimale Uniformität bei einer charakteristischen Impulspause $t_{eff}$ erreicht wird.

Bei der Beschichtung von derartig gewölbten Substraten wurden mit den so gewählten Prozeßparametern Uniformitätszahlen (=minimale Schichtdicke/maximale Schichtdicke) bis 0,99 erreicht. Abhängig von der gewünschten Substratuniformität kann u.U. auf eine weitere Optimierung der Verfahrensparameter verzichtet werden.


ii. Linsen mit stärkerer Wölbung und/oder nicht-rotationssymmetrischer Wölbung.


Für Linsen mit starker Wölbung und/oder nicht-rotationssymmetrischer Form reicht die Verwendung einer konventionellen Gasdusche nicht aus, um für z.B. Antireflexbeschichtungen notwendige Uniformitätszahlen von größer 0,98 zu erreichen. In diesem Fall hat es sich als vorteilhaft erwiesen, zur weiteren Optimierung der Uniformität als Gasdusche eine Gaszonendusche zu verwenden, die mindestens zwei Zonen enthält. Die zu optimierenden Parameter sind dann die geometrische Anordnung der Gaszonen (Zonenparameter) sowie die Zusammensetzung und Massenflüsse der Prozeßgase durch die einzelnen Zonen (Zonengasparameter).

Zunächst ermittelt man für eine Gaszonendusche bei einer willkürlichen Aufteilung der Prozeßgase in der Gaszonendusche, vorzugsweise jedoch mit einer Aufteilung, bei der das Prozeßgas derart in Teilströme durch die Zonen aufgeteilt wird, daß die Massenflußdichte und Zusammensetzung des Prozeßgases an jeder Stelle der Zonendusche gleich ist, über die Änderung der Schichtdickenverteilung auf dem Substrat als Funktion der Impulspause die charakteristische Zeit $t_{eff}$, bei der die Uniformität optimal ist. Hierbei werden die Startwerte analog i. gewählt.

Anschließend ändert man die Zusammensetzung und/oder Massenflüsse der durch die Zonen fließenden Gase derart, daß die Konzentration des Schichtbildners und/oder der Massenfluß von schichtbildnerhaltigem Gas an solchen Stellen der Gasdusche erhöht werden, an denen auf dem gegenüberliegenden Substrat die Schichtdicke zu gering war und umgekehrt, wobei in erster Näherung als Impulspause der eben ermittelte Wert $t_{eff}$ genommen wird. Ist die Uniformität nicht ausreichend hoch, kann iterativ in der oben beschriebenen Weise die Uniformität durch Neubestimmung von $t_{eff}$ mit ggf. anschließender Anpassung der Zonengasparameter weiter optimiert werden. Ebenso hat es sich als vorteilhaft erwiesen, auch die übrigen Prozeßparameter, wie z.B. den Prozeßdruck einer Feinabstimmung zu unterziehen. Die so ermittelten Prozeßparameter gewährleisten Uniformitätszahlen von nahezu 1.00.

Alternativ dazu kann die Optimierung nach Methoden der statistischen Versuchsplanung (Box and Hunter, Statistics for Experimenters, John Wiley & Sons, N.Y. 1978) unter Variation der Zonengasparameter und der Impulspause erfolgen.

In der Regel reicht es aus, eine lediglich 3-zonige Gaszonendusche zu verwenden. Vorzugsweise wird eine Gaszonendusche mit einer zentralen kreisförmigen und einer mittleren sowie äußeren ringgörmigen Zone verwendet.

Für Linsen mit schwacher Wölbung wurde gefunden, daß die Zonengasparameter maximal bis zu +/- 10% gegenüber den Einstellungen für eine konventionelle Gasdusche verändert werden müssen, um das optimale Schichtdickenprofil zu erhalten. Bei sehr komplexen Formen kann es erforderlich sein, die Zahl der Zonen zu erhöhen. Insbesondere erfordern nicht-rotationssymmetrische Formen auch nicht-rotationssymmetrische Zoneneinteilungen.

Es hat sich gezeigt, daß bei einem Kammerdruck von 50 Pa (0,5 mbar) und einem Gesamtmassenfluß von 50 sccm für HMDSO/$O_2$-Gasmischungen der Wert $t_{eff}$ bei niedrigen HMDSO-Konzentrationen (< 10%) im Bereich 10-50 ms, für hohe HMDSO-Konzentrationen (> 30%) kleiner 10 ms ist; während für $TiCl_4$/$O_2$-Gasmischungen $t_{eff}$-Werte zwischen etwa 50-100 ms annimmt. Die $t_{eff}$-Werte hängen etwa umgekehrt proportional vom Kammerdruck und vom Massenfluß ab. Die Abhängigkeit der $t_{eff}$-Werte von den Gaszusammensetzung hängt vermutlich mit besonderen chemischen Prozessen bei der Abscheidung, die auch das Plasma beeinflussen, zusammen.

Zur Reduzierung der die Qualität der Beschichtung beeinträchtigenden Gasphasenreaktion wird der Prozeßdruck P in der Reaktionskammer vorzugsweise so gewählt, daß P x H zwischen 50 Pa (0,5 mbar und 3000 Pa (30 mbar) x mm liegt, wobei H der Abstand Substrat/Gasdurchlaßfläche bezeichnet.

Die Länge der Plasmaimpulse sollte möglichst nicht länger sein als dic Zeit, die die Schichtbildnermoleküle im Mittel benötigen, um etwa 1/10 der Strecke des Substratdurchmessers zurückzulegen. Bei einem Druck von 50 Pa (0,5 mbar) haben sich beispielsweise Pulsdauern zwischen 0,1 und 2 ms für Oxidationsreaktionen von HMDSO und $TiCl_4$ zu $SiO_2$ bzw. $TiO_2$ als geeignet erwiesen.

Die Dicke der Beschichtung kann bei vorgegebenen Volumina $V_i$ somit über die räumlich zugeordneten Konzentrationen $K_i$ eingestellt werden. Hierbei ist es von Vorteil, wenn die Substratoberfläche nicht zu weit entfernt von der Gasdurchlaßfläche positioniert wird, so daß $h_i$ und damit bei festem $F_i$ auch $V_i$ möglichst gering ist, um keine unkontrollierten Gasströmungen im Reaktionsraum entstehen zu lassen, da der Grad der Vermischung der unterschiedlichen Gasarten und/oder Konzentrationen weitgehend kontrolliert ablaufen muß. Hierzu ist der Abstand H von Gasdurchlaßfläche und Substratoherfläche vorzugsweise variierbar, so daß unterschiedliche Volumina für den vom Plasma angefüllten Reaktionsraum einstellbar sind. Als vorteilhafte Abstände haben sich Werte zwischen 2mm und 20mm für H herausgestellt. Hierbei ist zu beachten, daß das Verhältnis von kleinstem zu größtem Duschenabstand für ein Substrat zwischen 0,3 und < 1 liegt, wobei Werte um 1 für planare Substrate gelten. Der Linsendurchmesser kann zwischen 10 und 150 mm liegen.

Da die Temperatur der Frischgase die Beschichtungsrate beeinflußt, wird die Dusche zweckmäßigerweise auf eine Temperatur zwischen 20° und 100° C thermostatisiert. Wichtig ist eine definierte Temperatur der Gasdurchlaßfläche, die vorzugsweise aus Metall besteht, da diese eine Begrenzungsfläche des Plasmas ist.

Vorzugsweise wird das Restgas über den Rand der Gaszonendusche abgepumpt und im Zentrum zugeführt. Für rotationssymmetrische Substrate ist es von Vorteil, wenn das Restgas rotationssymmetrisch abgepumpt wird.

Da sich jede Beschichtung aus mehreren Einzelschichten zusammensetzt, wie dies beispielsweise bei den Kratzschutzschichten und Antireflexschichten auf Brillengläsern der Fall ist, sind mehrere Beschichtungsvorgänge notwendig. Die Kratzschutz- und die Antireflexbeschichtung kann dabei ohne Fluten des Reaktionsraumes nacheinander durchgeführt werden, da infolge des begrenzten Reaktionsraumes und der hohen Plasmadichte die Materialumsetzung nahezu vollständig erfolgt und damit die Partikelbildung weitgehend unterdrückt ist.

Als Plasmaimpulsverfahren kann ein Mikrowellen-PICVD-Verfahren eingesetzt werden oder die Plasma-CVD-Abscheidung kann durch HF-Impulse angeregt werden, wobei die Feldstärke der anregenden elektromagnetischen Strahlung in dem zur Beschichtung beitragenden Raum über der zu beschichtenden Oberfläche des Substrats einen Schwellenwert überschreitet, der zur Umsetzung des schichtbildenden Gases in Schichtmaterial erforderlich ist.

Vorteilhafterweise wird das elektromagnetische Feld zur Erzeugung des Plasmas so eingestellt, daß es in seiner Symmetrie an die Substratsymmetrie angepaßt ist: beispielsweise Rotationssymmetrie bei rotationssymmetrischen Substraten, wie Brillengläsern. Wie dies zu geschehen hat, beispielsweise mit Hilfe einer Stub-Tuner Einheit, die Interferenzeffekte ausnutzt, ist dem Fachmann geläufig und z.B. in Meinke/Gundlach, Taschenbuch der HF-Technik, Springer-Verlag Berlin (1968) beschrieben.

Wenn zwei Oberflächen eines Substrates beschichtet werden sollen, so kann dies gleichzeitig geschehen, wobei jede Oberfläche einer eigenen Gasdurchlaßfläche gegenüber angeordnet wird.

Es besteht aber auch die Möglichkeit, beide Oberflächen nacheinander zu beschichten, wobei die jeweils freie Oberfläche, die gerade nicht beschichtet werden soll, geschützt werden muß. Dies kann dadurch geschehen, daß die jeweils freie Oberfläche sich in einer Kammer befindet, in der der Druck so niedrig gehalten wird, daß kein Plasma zünden kann (ca. < 0,1 Pa (0,001mbar)).

Das erfindungsgemäße Beschichtungsverfahren wird insbesondere für eine Antireflexbeschichtung auf Linsen und Brillengläsern aus Glas oder für eine Kratzschutz- und Antireflexbeschichtung für Brillengläser und Linsen aus Kunststoff oder kratzempfindlichem Material angewendet. Die zu beschichtenden Substrate bestehen beispielsweise aus Glas, Polycarbonat oder CR 39 (CR 39 ist Diethylenglykol-bis-allylcarbonat).

Das Verfahren zur Ermittlung der Prozeßparameter wird vorzugsweise wie folgt durchgeführt:

Nach Einsetzen des Substrates in die Substrathalterung wird diese in die Beschichtungsanlage eingebaut, welche z.B. nach einem Mikrowellen-Plasma-Impuls CVD-Verfahren arbeitet. Das gewünschte Schichtsystem mit der jeweiligen Dicke der zugehörigen Einzelschichten sowie die Prozeßparameter werden dann in den Steuerrechner der Anlage eingegeben, das Beschichtungsprogramm durch Knopfdruck gestartet und entsprechend dem Steuerprogramm abgearbeitet, wozu auch das Fluten und Öffnen der Anlage gehört. Als Prozeßparameter werden eingegeben: Zusammensetzung und Massenflüsse der durch die einzelnen Zonen einströmenden Gase, Startwert $t_A$ der Impulspause, Leistung der anregenden elektromagnetischen Strahlung, Druck im Reaktionsraum, der vorzugsweise zwischen 10 Pa (0,1 mbar) und 200 Pa (2 mbar) liegt und Temperatur der Gasduschenplatte.

Es wird dann die Beschichtung durchgeführt und das Schichtdickenprofil gemessen. Anschließend werden weitere Substrate desselben Typs auf die gleiche Weise beschichtet, wobei nur die Impulspause verändert wird. Ergeben die Messungen des Schichtdickenprofils keine Verbesserungen mehr bzw. zeigen sich bei weiteren Veränderungen der Impulspause - Verkürzung bzw. Verlängerung der Impulspause - wiederum Verschlechterungen des Schichtdickenprofils, dann ist hiermit die erste Versuchsreihe abgeschlossen, wobei dem besten Schichtdickenprofil die dazugehörige Impulspause als $t_{eff}$ zugeordnet wird. Danach wird die zweite Versuchsreihe mit weiteren Substraten desselben Typs unter Variation der Zonen- und Zonengasparameter durchgeführt, wobei $t_{eff}$ weitgehend konstant gehalten wird.

Es hat sich gezeigt. daß die Versuchsreihen nur für Grenzformen der Substrattypten durchgeführt werden müssen und daß die Parameter für die Beschichtung der Zwischenformen durch Interpolation der Prozeßparameter ermittelt werden können. Auf diese Weise kann der experimentelle Aufwand zur Ermittlung der Prozeßparameter reduziert werden.

Um eine Integration in einen Produktionsprozeß zu ermöglichen, wird die Beschichtung vorzugsweise mit kleiner Losgröße, vorzugsweise der Losgröße 1 durchgeführt.

Die Plasma-CVD-Vorrichtung ist durch die Merkmale des Patentanspruchs 13 gekennzeichnet. Diese Vorrichtung weist eine Gaszonendusche auf. Die Gaszonendusche besitzt planare Gasdurchläßflächen und vorzugsweise interne Elemente zur Vergleichmäßigung der Massenflußdichte in der Gasdusche bzw. in den einzelnen Gaszonen.

Die Gasdurchlasßfläche ist vorteilhafterweise mit Löchern für den Gasdurchtritt versehen und unterhalb der Gasdurchlaßfläche sind Zonenelemente als Gasverteilungssysteme angeordnet, die die Zonen definieren und/oder über eine Verstelleinrichtung veränderbar sind und/oder mindestens eine flexible Wand aufweisen und/oder daß eine Marke mit vorgegebenem Lochmuster zwischen Gaszonendusche und Substrat vorgesehen ist.

Die einzelnen Zonen der Gaszonendusche sind an Zuführleitungen für Frischgas angeschlossen, denen über steuerbare Einrichtungen jeweils vorgegebene unterschiedliche Mengen an Schichtbildnergas zugemischt werden können, so daß das über die Zonen in die Reaktionskammer eingeleitete Frischgas jeweils unterschiedliche Konzentrationen an schichtbildendem Material enthalten kann. Überraschenderweise haben sich Gaszonenduschen, die bisher lediglich für die Beschichtung von ebenen Substraten verwendet wurden, auch bei der Beschichtung gewölbter Substrate bewährt.

Die Gaszonendusche ist für kreissymmetrische Substrate beispielsweise aus mindestens zwei konzentrischen Zylindern aufgebaut, die individuell mit Gasmischungen beschickt werden, wobei der Gasmassenfluß aus einem Zylinder auch Null sein kann, so daß dann der Durchmesser des Zylinders im Vergleich zur Substratgeometrie für die Uniformität entscheidend ist. Bei Linsen mit astigmatischer Wirkung (z.B. Zylinderlinsen) sind die Zylinder der Gaszonendusche vorzugsweise in Richtung der Achse des Zylinders der Zylinderlinse deformiert, z.B. zu einer Ellipse oder einem Rechteck. Dies muß zumindest für den Zonenzylinder gelten, der den größten Beitrag der Beschichtungsgasmischung liefert. Um für unterschiedliche Substrate mit und ohne astigmatischer Wirkung flexibel zu sein, sind die konzentrischen Zonen vorzugsweise reversibel elliptisch verformbar.

Eine weitere Flexibilität der Vorrichtung wird dadurch erreicht, daß der Abstand zwischen der Kopfplatte der Gaszonendusche und der zu beschichtenden Oberfläche einstellbar ist. Der eigentliche Reaktionsraum kann dabei ein Volumen zwischen 1 und 500 cm$^3$ aufweisen. Vorzugsweise weist die Gaszonendusche im Bereich der Zonen in der Kopfplatte Bohrungen mit Durchmessern von 0,1 bis 10 mm auf.

Zusätzlich können in der Plasma-CVD-Vorrichtung zwischen der Gasdurchtrittsfläche und dem zu beschichtenden Substrat eine oder mehrere Masken vorgesehen sein, mit welchen eine vorgegebene Verteilung der Gasströme auf die Substratoberfläche erzielt werden kann. Das Muster der einzelnen Masken ist dabei auf die Oberflächenform des zu beschichtenden Substrats abgestimmt. Vorzugsweise können daher auch Masken, welche in die Substrathalterung integriert sind, zum Einsatz kommen.

Wenn die beiden Oberflächen eines Substrates nacheinander beschichtet werden sollen, so befindet sich das Substrat in der Trennwand zwischen der Reaktionskammer und einer Vakuumkammer, so daß die jeweils nicht zu beschichtende Oberfläche des Substrates sich in der Vakuumkammer befindet und die zu beschichtende Oberfläche in der Reaktionskammer. Der Druck in der Vakuumkammer wird so niedrig eingestellt, daß kein Plasma zünden kann. Auf diese Weise wird verhindert, daß während der Beschichtung der einen Seite auch eine Beschichtung der anderen Seite, die allerdings dann unter unkontrollierten Bedingungen stattfinden würde, erfolgt.

Zum Erzeugen und Anregen des Plasmas ist eine Mikrowelleneinrichtung vorgesehen. Dabei wird, wenn auf beiden Seiten des Substrats ein Plasma erzeugt wird, die Reaktionskammer vorzugsweise in einem Mikrowellenrechteck-Hohlleiter eingebaut, wobei die Gaszonendusche so ausgebildet ist, daß die Gaszuführung und die Gasabsaugung durch die breiten Seiten des Rechteckhohlleiters erfolgen.

In einer weiteren bevorzugten Anordnung ist die Reaktionskammer kann auch in einem Zylinderresonator eingebaut, wobei die Kopfplatte vorzugsweise mit den Zylinderböden identisch ist, so daß die Gaszuführung und die Gasabsaugung durch die Zylinderböden erfolgen können. Die Einkopplung der Mikrowellen in den Zylinderresonator erfolgt vorzugsweise aus einem umlaufenden Rechteckhohlleiter, der Schlitze aufweist, so daß eine Schlitzkopplung möglich ist. Eine weitere Möglichkeit besteht in einer Drahtschleifenkopplung.

Gemäß einer weiteren bevorzugten Ausführungsform erfolgt die Einkopplung der Mikrowellen in den Zylinderresonator mittels einer Lisitanospule.

Wenn eine gleichzeitige Beschichtung beider Seiten vorgesehen ist, so ist die Substrathalterung im Zentrum der Reaktionskammer angeordnet und jeder der zu beschichtenden Oberflächen ist eine eigene Gaszonendusche zugeordnet.

Beispielhafte Ausführungsformen der Erfindung werden nachfolgend anhand der Zeichnungen näher erläutert.

Es zeigen:

Figur 1            eine schematische Darstellung der Vorrichtung mit Gaszonendusche,

Figur 2            eine Vorrichtung für die einseitige Beschichtung,

Figur 3            eine Vorrichtung für die gleichzeitige, beidseitige Beschichtung gemäß einer ersten Ausführungsform,

Figur 4            eine Vorrichtung für die gleichzeitige, beidseitige Beschichtung gemäß einer weiteren Ausführungsform,

Figur 5            eine Vorrichtung für die gleichzeitige, beidseitige Beschichtung gemäß einer weiteren Ausführungsform,

Figur 6            eine Vorrichtung gemäß einer weiteren Ausführungsform,

Figur 7a,b        eine Gaszonendusche mit verstellbaren Zonen,

Figur 8            eine Substrathalterung mit integrierten Masken für gleichzeitige beidseitige Beschichtung,

Figuren 9a-d      Schichtdickenprofile einer $TiO_2$-Schicht auf einem konkaven Substrat mit einer konventionellen Gasdusche,

Figuren 10a-f      Schichtdickenprofile einer $SiO_2$-Schicht auf einem konvexen Substrat (erste Versuchsreihe),

Figur 11      Schichtdickenprofile einer $SiO_2$-Schicht auf einem konvexen Substrat für kurze Impulspausen,

Figur 12      ein nach der zweiten Versuchsreihe optimiertes Schichtdickenprofil einer $SiO_2$-Schicht auf einem konvexen Substrat,

Figur 13      Schichtdickenprofile für eine $SiO_2$-Schicht auf einem gekrümmten Substrat für eine Impulspause von $t_{eff} = 10$ msec für unterschiedliche Zonenparameter,

Figuren 14a-d      Schichtdickenprofile einer $TiO_2$-Schicht für verschiedene Impulspausen und Zonenparameter und

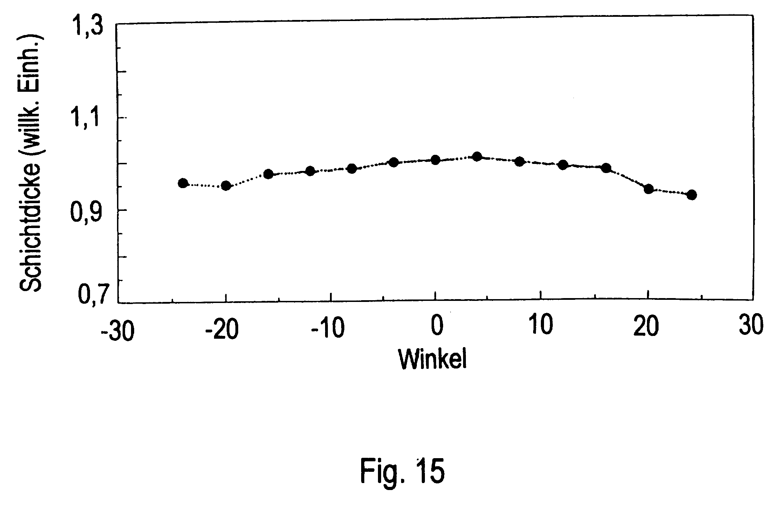

Figur 15      das Schichtdickenprofil einer $SiO_2$-Schicht auf einem konkaven Substrat am Ende der zweiten Versuchsreihe.

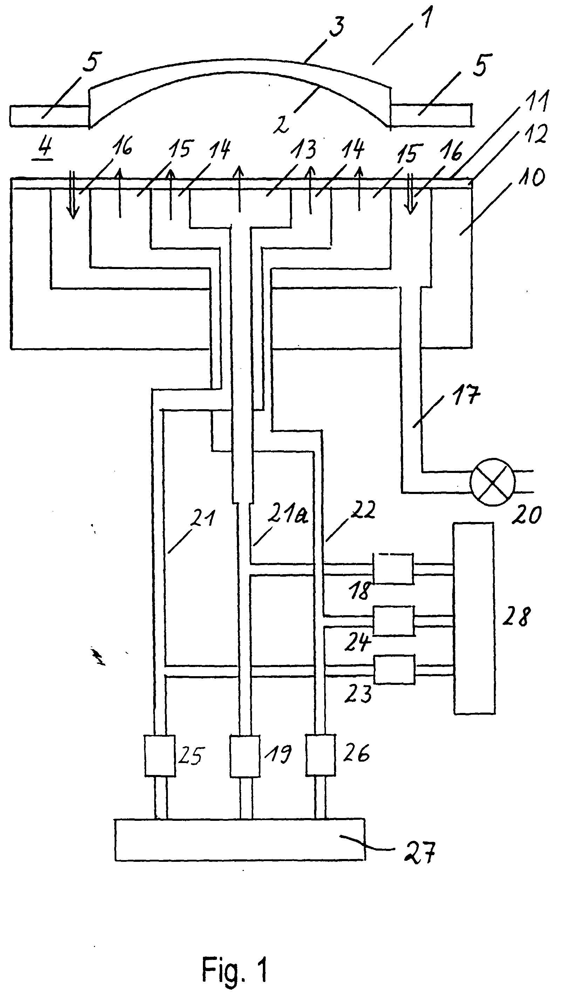

In der Figur 1 ist eine schematische Darstellung einer Plasma-CVD-Vorrichtung für die Beschichtung von gewölbten Substraten dargestellt. Das Substrat 1 mit den Oberflächen 2 und 3 ist in einem Substrathalter 5 gehalten, der mindestens teilweise aus einem Dielektrikum besteht, so daß im Falle eines Mikrowellen-angeregten Plasmas die Mikrowellenausbreitung nicht behindert wird. Die zu beschichtende konkave Substratoberfläche begrenzt den Reaktionsraum 4, der an der Unterseite von einer Kopfplatte 12 einer Gaszonendusche 10 begrenzt wird. Die Oberseite der Kopfplatte 12 bildet die Gasdurchlaßflächen 11. Die Gaszonendusche 10 weist vier Zonen 13, 14, 15 und 16 auf, wobei die äußere außerhalb des Substrates liegende Zone 16 zum Absaugen der Restgase dient. Die Zone 16 ist daher über die Absaugleitung 17 mit einer Pumpe 20 verbunden. Die Zonen 13, 14 und 15 für die Zuführung von Frischgasen sind über die Zuführleitungen 21, 21a und 22 mit Gasmassenflußreglern 19, 25, 26 an eine Quelle für nicht schichtbildendes Gas 27 sowie über Gasmassenflußregler 18, 23, 24 an eine Gasquelle 28 für die Zuführung von Frischgas angeschlossen.

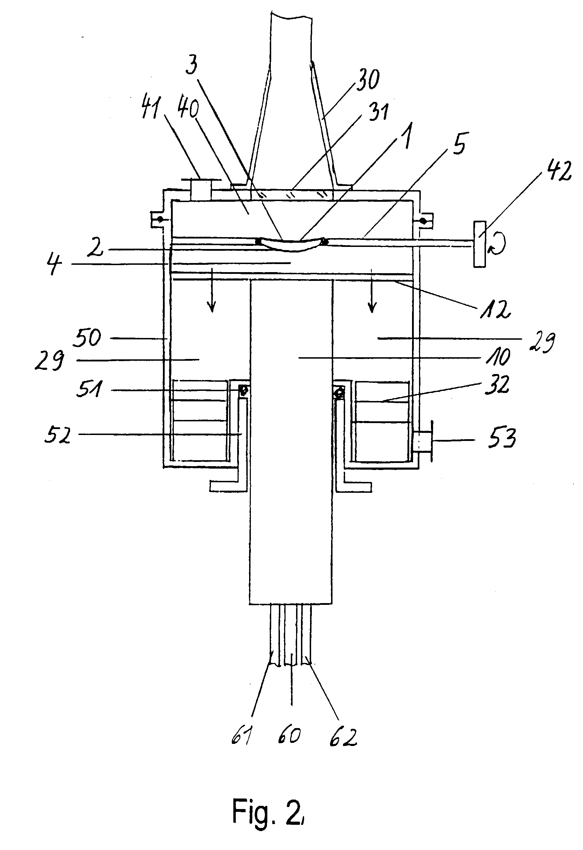

In der Figur 2 ist eine Vorrichtung dargestellt, mit der beide Seiten eines Substrates 1 nacheinander beschichtet werden können. Das Substrat 1 ist zwischen einer Vakuumkammer 40 und der Reaktionskammer 50 in einer Substrathalterung 5 angeordnet. Beide Kammern 40, 50 sind durch Halterung 5 und Substrat 1 mittels einer üblichen O-Ring-Dichtung (nicht gezeichnet) gasdicht voneinander getrennt. Die Vakuumkammer 40 ist an eine Absaugleitung 41 angeschlossen, so daß in der Vakuumkammer 40 ein Druck eingestellt werden kann, der niedriger ist als der Druck in der Reaktionskammer 50, so daß beim Erzeugen des Plasmas im Reaktionsraum 4 keine Plasmareaktion in der Vakuumkammer 40 stattfindet. Dadurch wird verhindert, daß die Oberfläche 3 des Substrates 1 einer ungewollten Beschichtung ausgesetzt wird.

Die Mikrowellen zum Erzeugen und Anregen des Plasmas werden über einen Hohlleiter 30 eingestrahlt, dessen Ende über ein Mikrowellenfenster 31 gegenüber der Vakuumkammer 40 abgeschlossen ist. Die Reaktionskammer 50 wird begrenzt durch die Gaszonendusche 10, die über die Zuführleitungen 60, 61, 62 mit Frischgas versorgt wird. Die Gaszonendusche 10 wird von einer Führung 52 gehalten und ist in dieser verschiebbar angeordnet. Die Gaszonendusche ist über Dichtelemente 51, die über die Führung 52, die gleichzeitig als Schraube ausgebildet ist, angedrückt wird, vakuumdicht mit der Reaktionskammer 50 verbunden. Nach Lösen der Führung 52 läßt sich die Gaszonendusche 10 auf einen vorgegebenen Abstand zum Substrat 1 bringen. Eine andere Möglichkeit besteht darin, die Gaszonendusche 10 mit der Reaktionskammer 50 über einen vakuumdichten Wellschlauch zu verbinden, so daß das Einstellen des Abstandes zwischen Substrat 1 und der Gaszonendusche 10 ohne zusätzliche Maßnahmen, sogar während einer Beschichtung erfolgen kann.

Über die äußere Ringzone 29 wird das Restgas durch die elektrisch leitfähige Kopfplatte 12 der Gaszonendusche 10 abgesaugt, wobei Leitbleche 32 die seitlich eingekoppelte Saugleistung rotationssymmetrisch machen oder die Einstellung eines vorgegebenen azimutalen Verteilungsprofiles gestatten. Die Absaugung der Restgase erfolgt über die Restgasleitung 53. Mittels der Dreheinrichtungen 42 kann nach erfolgter Beschichtung das Substrat 1 mit der Halterung 5 gedreht werden, so daß auch die konvexe Oberfläche 3 in einem zweiten Vorgang beschichtet werden kann.

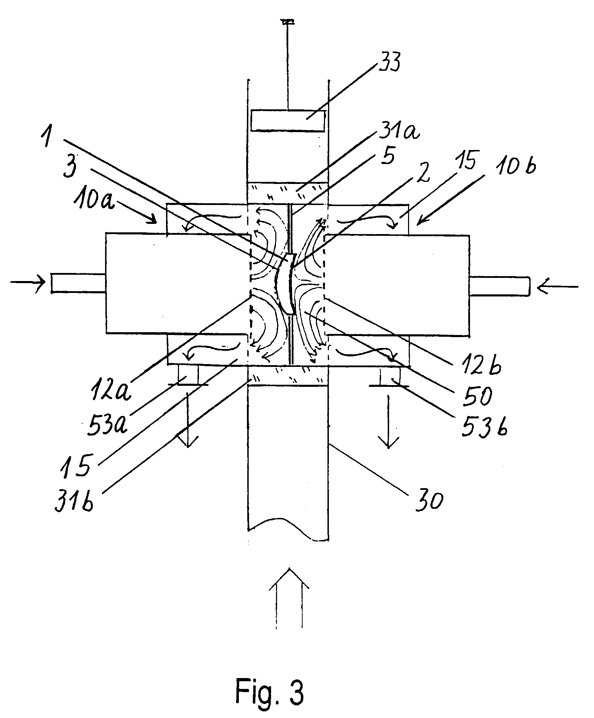

In der Figur 3 ist eine Vorrichtung zum gleichzeitigen, beidseitigen Beschichten eines Substrates 1 dargestellt, das sich im Zentrum einer Reaktionskammer 50 befindet. Auf den beiden gegenüberliegenden Seiten der Oberflächen 2 und 3 sind Gaszonenduschen 10a, 10b angeordnet, deren Kopfplatten 12a, 12b Bestandteil des Rechteckhohlleiters 30 sind, über den die Mikrowellen in die Reaktionskammer 50 eingekoppelt werden. Die Reaktionskammer 50 wird über die Mikrowellenfenster 31a, 31b abgeschlossen. Auf der gegenüberliegenden Seite des Mikrowellen-Rechteckhohlleiters 30 ist ein Kurzschlußschieber 33 vorgesehen. Die Gaszonenduschen 10a, 10b weisen mehrere konzentrische Zonen auf, durch die das Frischgas in die Reaktionskammer 50 eingeleitet wird. Über eine äußere Ringzone 15 wird das Restgas abgesaugt.

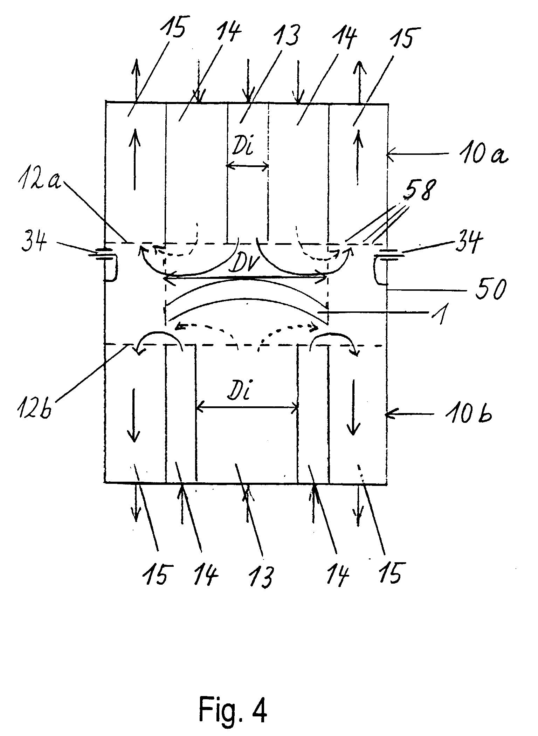

In der Figur 4 ist eine weitere Ausführungsform dargestellt, wobei die Reaktionskammer 50 Bestandteil des Zylinderresonators ist. Die Einkopplung der Mikrowellen erfolgt über eine induktive Einkopplung 34. Die beiden dem Substrat 1 gegenüberliegenden Gaszonenduschen 10a und 10b unterscheiden sich hinsichtlich der Größe der Zonen 13, 14 und 15. Der Durchmesser des zu beschichtenden Substrates ist in der hier gezeigten Darstellung $D_v$. Der Innendurchmesser $D_i$ der zentralen Zone 13 der unteren Gaszonendusche 10b für die Beschichtung der konvexen Seite liegt nur wenig unterhalb des Durchmessers $D_v$ des Substrates und beträgt etwa 0,8 x $D_v$. Die Zone 14 ist dementsprechend relativ schmal ausgebildet.

Bei der oberen Gaszonendusche 10a für die Beschichtung der konkaven Seite liegt der Innendurchmesser der zentralen Zone 13 lediglich bei einem Durchmesserwert von 0,2 x $D_v$. Dementsprechend ist die Zone 14 größer ausgestaltet. Die Zonen 15 sind in den Gaszonenduschen 10a und 10b gleich groß ausgebildet.

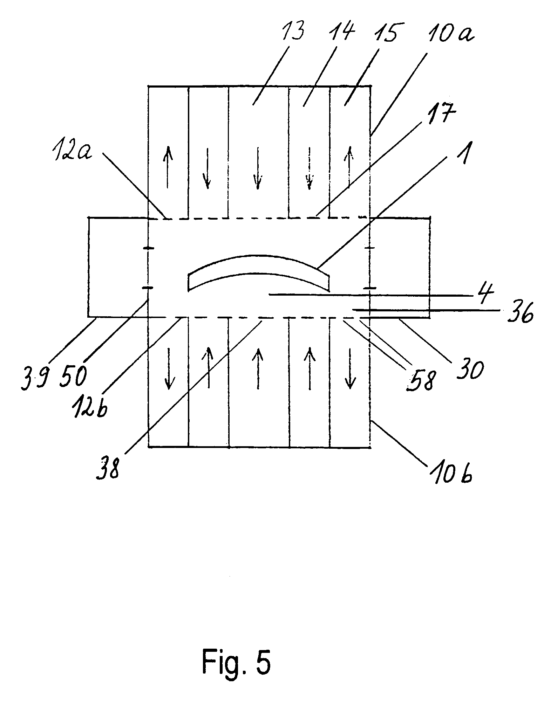

In der Figur 5 ist eine weitere Ausführungsform dargestellt, bei der die Reaktionskammer 50 in Form eines Zylinderresonators 36 ausgebildet, und von einem Rechteckhohlleiter 39 umgeben ist. Dieser besitzt Schlitze zur Einkopplung der Mikrowellen in den Reaktionsraum 4. Die Kopfplatten sind mit den Zylinderböden 37, 38 identisch.

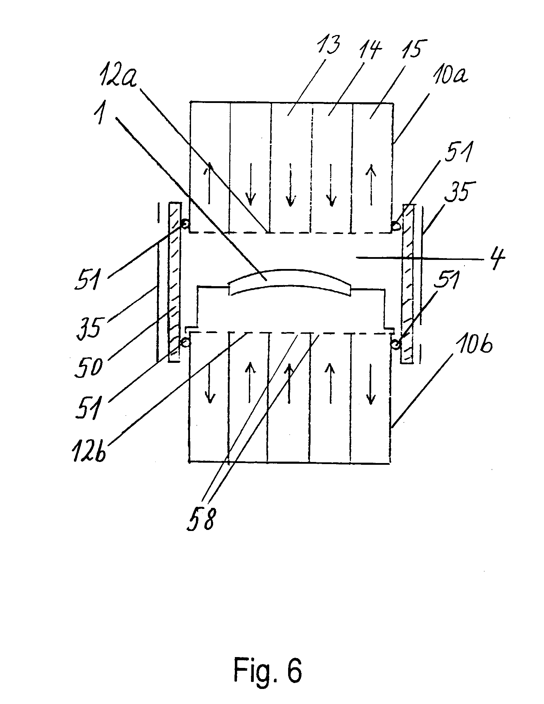

In der Figur 6 ist eine weitere Ausführungsform dargestellt, wobei die Reaktionskammer 50 von einer Lisitano-Spule 35 umgeben ist.

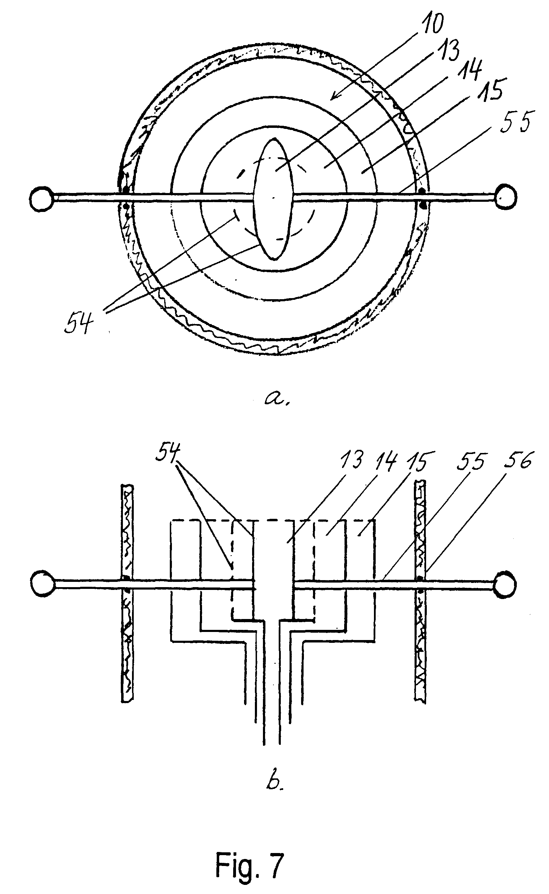

Figuren 7a,b zeigen in Prinzipdarstellungen eine Gaszonendusche mit drei Zonen 13,14,15, bei der der innere Zylinder 54 von außen reversibel elliptisch verformt werden kann. Eine derartige Gaszonendusche 10 eignet sich auch zur Beschichtung von astigmatischen Brillengläsern, wenn die Zylinderachse des Substrats in Richtung der großen Ellipsenachse angeordnet ist.

Der verformbare Zylinder 54 besteht aus flexiblem Material, beispielsweise aus 0,1mm dickem Edelstahlblech, mit dem beidseitig starr oder gelenkig Betätigungswellen 55 verbunden sind. Die Wellen 55 durchstoßen die übrigen Zylinder und können über Schiebedurchführungen in der Außenwand 56 des Reaktors betätigt werden. An die Dichtigkeit der Bohrungen in den Zylindern mit durchgesteckter Welle 55 sind keine hohen Anforderungen zu stellen, da der Druckunterschied zwischen den Zylindern sehr klein ist. Die Welle 55 sollte je nach ihrem Durchmesser und dem Druck in der Gaszonendusche einen ausreichenden Abstand zur Kopfplatte aufweisen, damit das Strömungsprofil des austretenden Gases nicht gestört wird.

Je nachdem, ob durch den elliptisch verformten Zentralzylinder Frischgas oder beispielsweise ein schichtbbildnerfreies Gas strömt, wird die örtliche Beschichtungsrate in diesem Bereich des Substrats angehoben oder vermindert, so daß Brillengläser mit entgegengesetzten zylindrischen Wirkungen beschichtbar sind.

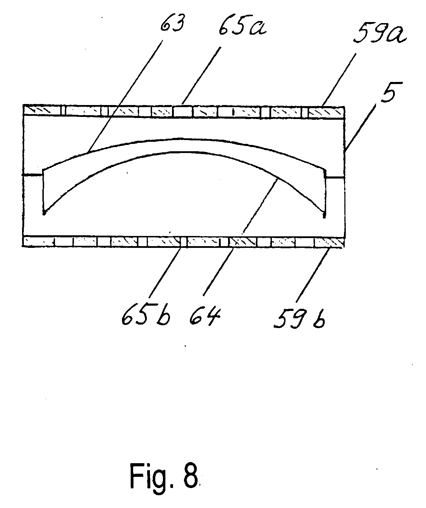

Figur 8 zeigt zwei in eine Substrathalterung integrierte Masken 59 für gleichzeitige, beidseitige Beschichtung. Hier ist zu sehen, daß die der konvexen Substratoberfläche 63 zugeordnete Maske 59a in der Mitte, wo der Abstand Maske-Substrat am kleinsten ist, die Löcher 65 einen größeren Durchmesser aufweisen als in den peripheren Bereichen, wo der Abstand Maske-Substrat größer ist. Auf der gegenüberliegenden Seite sind bei der der konkaven Substratoberfläche 64 zugeordneten Maske 59b die Verhältnisse genau umgekehrt. Entscheidend ist, daß die Größe der Maskenlöcher 65 so bemessen ist, daß der Zufluß des Frischgases nicht beeinflußt wird und daß die Zufuhr der zur Beschichtung des Substrates beitragenden schichtbildenden Moleküle entsprechend der vorgegebenen Toleranz der Schichtdicke konstant ist.

Mit einer Vorrichtung gemäß Figur 1 und 2 , wobei eine dreizonige Gaszonendusche mit einer kreisförmigen zentralen sowie einer ringförmigen mittleren und einer ringförmigen äußeren Zone verwendet wird, wurde eine erste Versuchsreihe durchgeführt. Vor Beginn der Versuchsreihe wurde durch Einstellen der Abstimmelemente (Stub-Tuner) ein rotationssymmetrisches Mikrowellenfeld erzeugt.

Es wurde die konkave Seite einer CR 39-Linse (Krümmungsradius 80mm, Linsendurchmesser 70mm) mit einer hochbrechenden TiO$_2$-Schicht versehen. Die Prozeßparameter waren wie folgt:

| Druck | 50 Pa (0,5 mbar) |
|---|---|
| Gesamtmassenfluß | 100 sccm |
| TiCl$_4$-Anteil | 6,3%. |

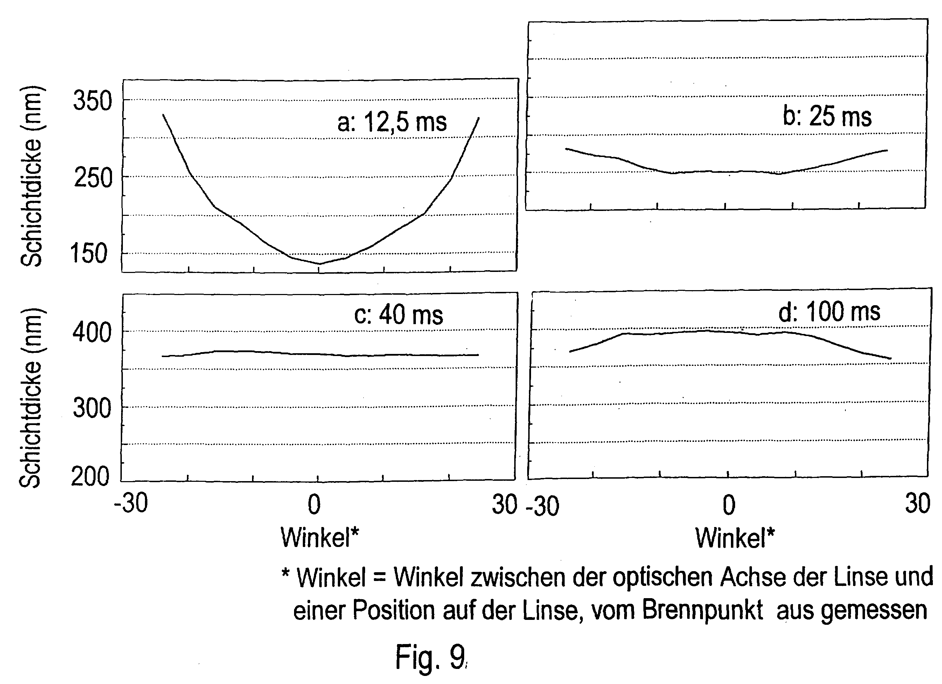

Als Gasdusche wurde eine konventionelle Gasdusche verwendet. Die Abhängigkeit der Uniformität von der Impulspause ist in Abb. 9a-d dargestellt, startend von einer Impulspause von 12,5 ms. Bei einer Impulspause von 40 ms wird eine optimale Uniformitätszahl von 0,982 erreicht, welche ausreichend für die optische Qualität einer Antireflexbeschichtung ist. Für längere Impulspausen nimmt die Uniformität wieder ab.

Es wurde die konvexe Seite einer CR 39-Linse (Krümmungsradius von 122mm, Linsendurchmesser 70mm) mit einer Kratzschutzschicht aus SiO$_2$ versehen. Die Prozeßparameter waren wie folgt:

| Prozeßdruck | 50 Pa (0,5 mbar) |
|---|---|
| Gesamtmassenfluß | 50 sccm |
| HMDSO-Anteil | linear sinkend von 35% auf 10%. |

Die Pulsleistung nahm linear von 2 kW auf 7 kW zu.

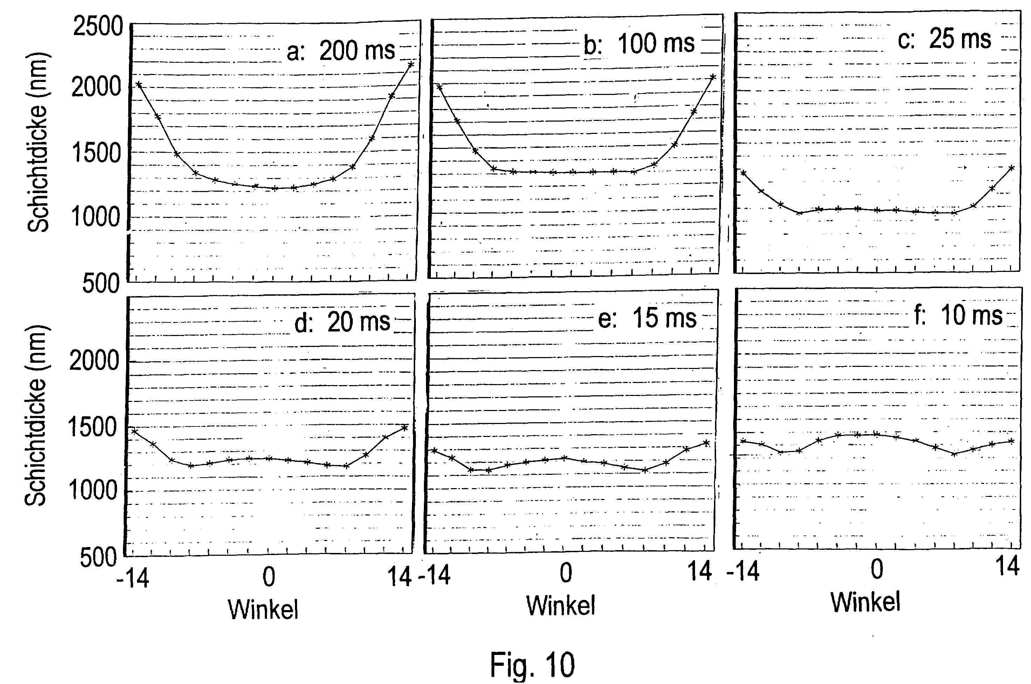

Um den Einfluß der Impulspause auf das Beschichtungsergebnis darzustellen, wurde mit einer Impulspause von 200 msec begonnen, wobei die Einstellung der Zonenparameter der Gaszonendusche konstant gehalten wurde (zentrale Zone der Gaszonendusche vollständig geöffnet und die übrigen Zonen vollständig geschlossen). Wie der Figur 10a zu entnehmen ist, ist eine deutliche Randüberhöhung festzustellen, die mit abnehmender Impulspause geringer wird, bis in Fig. 10f ein Schichtdickenverlauf erreicht worden ist, der nur noch zwischen 1200 und 1400 nm schwankt.

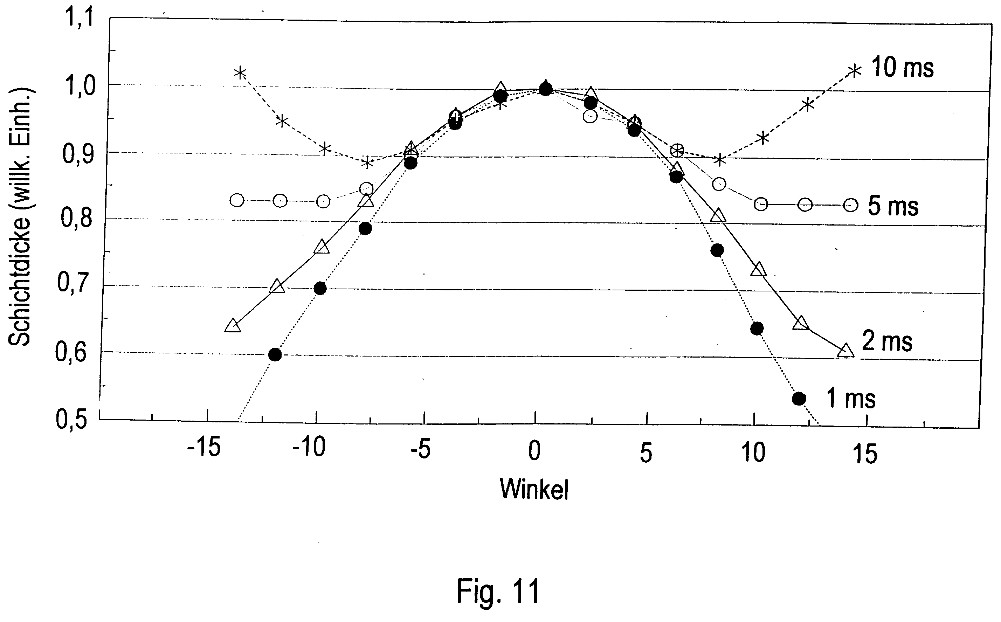

Geht man zu noch kürzeren Impulspausen über, wie dies in der Figur 11 dargestellt ist, so nimmt die Randüberhöhung ab und dafür zeigt sich eine Überhöhung im Zentrum des Substrates. Aus dieser Versuchsreihe ist zu entnehmen, daß die optimale Impulspause bei etwa 10 msec liegt.

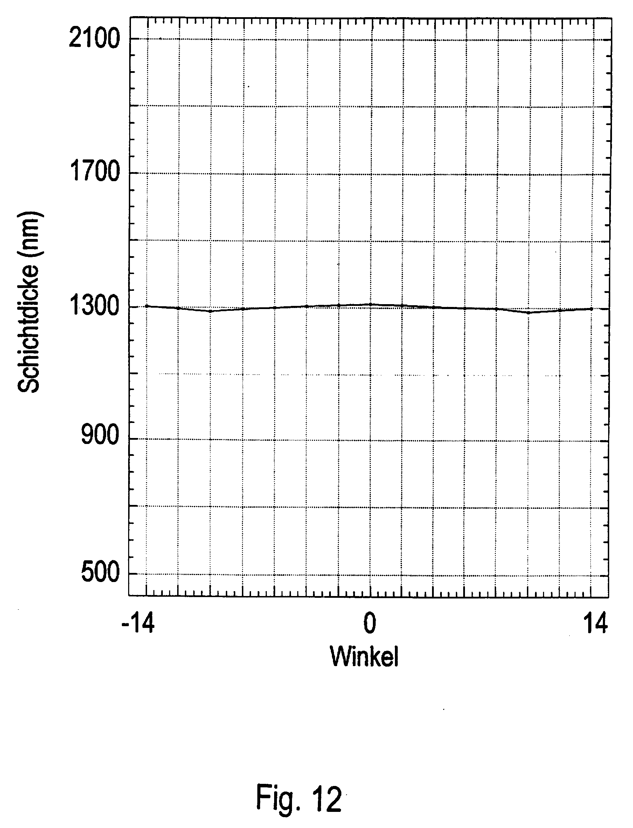

Durch eine geringfügige Veränderung der Massenflüsse konnte in der zweiten Versuchsreihe eine weitere Vergleichmäßigung des Schichtdickenprofils erreicht werden. Dies ist in der Figur 12 dargestellt. Die Gasmassenflüsse wurden gegenüber der Einstellung, die dem Schichtdickenprofil gemäß Figur 10f zugrundeliegt, in der mittleren Zone um ca. 6% erhöht.

In einer weiteren Versuchsreihe wurden, um den Einfluß der Einstellung der Zonenparameter, wie Größe der Gasdurchlaßfläche, Gasmassenflüsse etc., auf die Schichtdickenuniformität bei der optimalen Impulspause $t_{eff}$ zu demonstrieren, über die Gasdusche die Strömungsverhältnisse in der Reaktionskammer variiert.

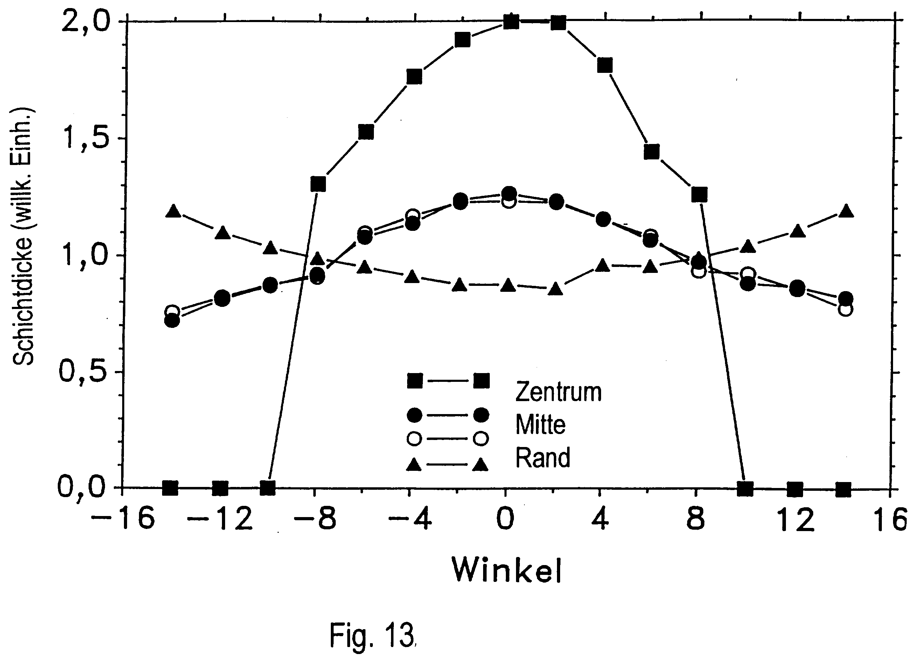

In der Figur 13 ist der Einfluß der Strömungsverhältnisse in der Reaktionskammer auf das Schichtdickenprofil dargestellt, wobei die Impulspause jeweils 10 msec betragen hat. Die Strömungsverhältnisse werden dadurch variiert, daß unterschiedliche Zonen geöffnet und geschlossen werden. Die Symbole geben an, welche Zone während des Beschichtungsverfahrens geöffnet war. Die jeweils übrigen Zonen waren bei dieser Versuchsreihe geschlossen.

Offensichtlich kan eine uniforme Schicht erreicht werden, wenn man den Schichtdickenverlauf der geöffneten Randzone mit dem der mittleren Zone überlagert.

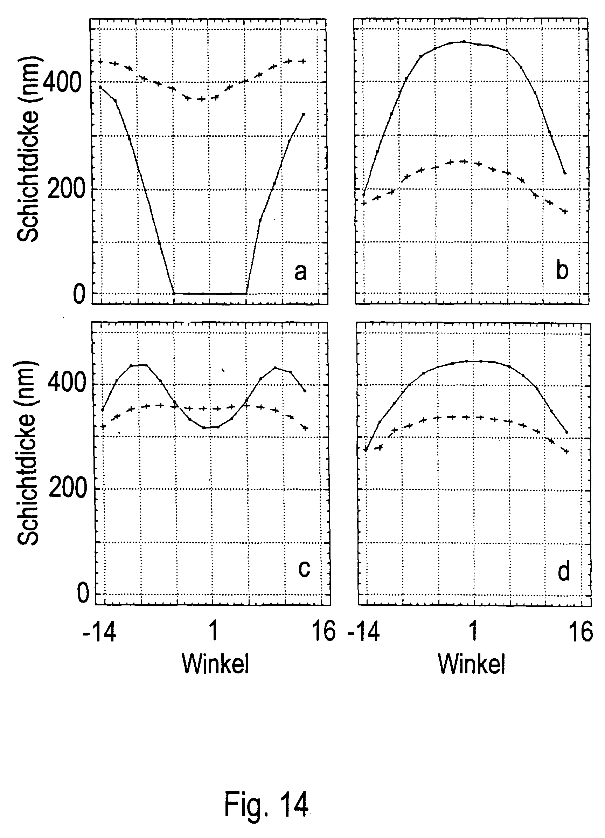

In den Figuren 14a-d wird der Einfluß der Gaszoneneinstellung auf das Schichtdickenprofil dargestellt, wobei zwei Impulspausen eingestellt worden sind. Es handelt sich hierbei um eine Beschichtung mit $TiO_2$. In Figur 14a sind alle Zonen bis auf die äußere ringförmige Zone geschlossen. Bei den Versuchen gemäß Figur 14b ist nur die zentrale Zone offen, gemäß Figur c die mittlere und gemäß der Figur d alle Zonen. Während bei einer nicht-optimalen Impulspause von 50 ms eine uniforme Schichtherstellung nur schwer möglich ist, kann bei einem Wert von 100 ms durch Überlagerung der Schichtdickenverläufe von Fig. 14a und Fig. 14b ein uniformer Schichtdickenverlauf eingestellt werden. So wurde bei vollständig geöffneter Randzone, geschlossener Mittenzone und 7,5% geöffneter Zentrumszone eine Uniformitätszahl von 0,992 erreicht.

**Patentansprüche**

1.    Verfahren zur Ermittlung von Prozeßparamatern für ein PICVD-Verfahren zur Herstellung von Beschichtungen gleichmäßiger Schichtdicke auf gewölbten Substraten, insbesondere auf Linsen aus Glas oder Kunststoff, bei dem die zu beschichtende Substratoberfläche gegenüber der Gasdurchlaßfläche einer Gasdusche angeordnet wird, durch welche schichtbildende Gase enthaltende Gasmischungen in eine Reaktionskammer strömen, wo durch zeitliche Impulspausen getrennte Plasmaimpulse erzeugt werden, dadurch gekennzeichnet,
daß für einen zu beschichtenden Substrattyp in einer ersten Versuchsreihe unter Konstanthaltung der Größe der Gasdurchlaßflächen und der Gasmassenflüsse durch die Gasdurchlaßflächen die Impulspausen ausgehend von einem Startwert $t_A$ schrittweise in eine Richtung zur Ermittlung eines optimalen Wertes $t_{eff}$ verändert werden, bis die auf den Substraten jeweils erzeugten Schichtdickenprofile keine weitere Vergleichmäßigung zeigen.

2.    Verfahren nach Anspruch 1, dadurch gekennzeichnet, daß als Gasdusche eine Gaszonendusche verwendet wird.

3.    Verfahren nach Anspruch 2, dadurch gekennzeichnet, daß in einer zweiten Versuchsreihe unter weitgehender Beibehaltung des Wertes $t_{eff}$ für die Impulspausen die Zonenparameter der Gaszonendusche, nämlich die Größe der Gasdurchlaßflächen und/oder die Gasmassenflüsse durch die Zonen, schrittweise verändert werden, bis die auf den Substraten jeweils erzeugten Schichtdickenprofile keine weitere Vergleichmäßigung zeigen.

4. Verfahren nach einem der Ansprüche 2 oder 3, dadurch gekennzeichnet, daß eine Gaszonendusche mit einer zentralen kreisförmigen und einer mittleren sowie äußeren ringförmigen Zone verwendet wird.

5. Verfahren nach einem der Ansprüche 1 bis 4, dadurch gekennzeichnet, daß als Startwert $t_A$ eine sehr lange Impulspause > 500msec eingestellt wird.

6. Verfahren nach einem der Ansprüche 1 bis 5, dadurch gekennzeichnet, daß das Restgas über den Rand der Gaszonendusche abgepumpt wird.

7. Verfahren nach einem der Ansprüche 1 bis 6, dadurch gekennzeichnet, daß das Restgas rotationssymmetrisch zum Substrat abgepumpt wird.

8. Verfahren nach einem der Ansprüche 1 bis 7, dadurch gekennzeichnet, daß ein Mikrowellen-PICVD-Verfahren verwendet wird.

9. PCVD-Verfahren zur Herstellung von Beschichtungen gleichmäßiger Schichtdicke auf gewölbten Substraten, insbesondere auf Linsen aus Glas oder Kunststoff, bei dem die zu beschichtende Substratoberfläche gegenüber der Gasdurchlaßfläche einer Gasdusche angeordnet wird, durch welche schichtbildende Gase enthaltende Gasmischungen (Frischgas) in eine Reaktionskammer strömen, wo durch zeitliche Impulspausen getrennte Plasmaimpulse erzeugt werden, dadurch gekennzeichnet,
daß die Beschichtung mit den gemäß dem Patentanspruch 1 ermittelten Prozeßparametern durchgeführt wird.

10. Verfahren nach Anspruch 9, dadurch gekennzeichnet, daß bei zwei zu beschichtenden Oberflächen eines Substrates diese nacheinander beschichtet werden, wobei die jeweils freie Oberfläche sich in einer Kammer befindet, in der der Druck so niedrig gehalten wird, daß kein Plasma erzeugt werden kann.

11. Verfahren nach Anspruch 9, dadurch gekennzeichnet, daß bei zwei zu beschichtenden Oberflächen eines Substrates diese gleichzeitig beschichtet werden, wobei jeder Oberfläche eine eigene Gaszonendusche gegenüber angeordnet wird.

12. Verfahren nach einem der Ansprüche 9 bis 11, dadurch gekennzeichnet, daß Frischgas der Reaktionskammer kontinuierlich zugeführt wird.

13. Plasma-CVD-Vorrichtung zur Herstellung von Beschichtungen gleichmäßiger Schichtdicke auf gewölbten Substraten wie L,insen, insbesondere für Brillengläser aus Glas oder Kunststoff,

- mit einer Reaktionskammer, in der eine Substrathalterung und mindestens eine Gasdusche angeordnet ist, die an einer Zuführleitung für Frischgas angeschlossen ist, welches aus dem über Regeleinrichtungen im Massenfluß einstellbaren Schichtbildnergas oder einer Mischung aus Schichtbildnergasen, dem Reaktionspartnergas und evtl. einem oder mehreren Inertgasen besteht und
- mit einer Mikrowellen-Einrichtung zur Erzeugung des Plasmas
- mit einer Einrichtung zur Verhinderung einer ungewollten Plasmabehandlung einer nicht zu beschichtenden Substratoberfläche, und
- mit einer Einrichtung zum Absaugen der Restgase nach einer Plasmazündung,

dadurch gekennzeichnet, daß

- die Gasdusche (10) eine planare Gasdurchlaßfläche (11) ist, die mit Löchern für den Gasdurchtritt versehen ist und unterhalb der Zonenelemente als Gasverteilungssysteme angeordnet sind, die die Zonen (13, 14, 15) definieren und/oder über eine Verstelleinrichtung (55) veränderbar sind und/oder mindestens eine flexible Wand aufweisen und/oder, daß eine Maske (59) mit vorgegebenem Lochmuster zwischen Gaszonendusche (10) und Substrat (1) vorgesehen ist,
- die Mikrowellen-Einrichtung im Bereich von 0,1 bis 500 ms pulsbar ist, wobei jeweils die Impulspause so eingestellt ist, daß beim Zünden des nächsten Impulses noch ein Restgasanteil des vorangegangenen Plasmaimpulses im Reaktionsraum verblieben ist,
- Mittel vorgesehen sind zur Aufrechterhaltung eines Unterdrucks von < 0,1 Pa ($10^{-3}$ mb) auf einer Seite der Substrathalterung bei eingespanntem Substrat,
oder

- Mittel vorgesehen sind zur gleichzeitigen Erzeugung des Plasmas auf beiden Seiten der Substrathalterung bei eingespanntem Substrat.

**14.** Vorrichtung nach Anspruch 13, dadurch gekennzeichnet, daß jede Zuführleitung (17,18) einen Gasmassenflußregler (25,26) aufweist.

**15.** Vorrichtung nach Anspruch 13 oder 14, dadurch gekennzeichnet, daß der Abstand zwischen der Gaszonendusche (10) und der zu beschichtenden Oberfläche (2,3) einstellbar ist.

**16.** Vorrichtung nach einem der Ansprüche 13 bis 15, dadurch gekennzeichnet, daß die Zonen (13,14,15,16) konzentrisch angeordnet sind.

**17.** Vorrichtung nach einem der Ansprüche 13 bis 16, dadurch gekennzeichnet, daß zur Beschichtung einer konvexen oder konkaven Oberfläche (2,3) eines runden Substrates (1) mit dem Durchmesser $D_V$ eine zentrale Zone (13) zur Gaszuführung vorgesehen ist, deren Innendurchmesser $D_i$ im Bereich von 0,1 x $D_V$ und $D_V$ liegt.

**18.** Vorrichtung nach einem der Ansprüche 13 bis 17, dadurch gekennzeichnet, daß die Reaktionskammer (50) in einen Mikrowellenrechteckhohlleiter (30) eingebaut ist und daß die Gaszonendusche (10) so ausgebildet ist. daß die Gaszuführung und die Gasabsaugung durch die breiten Seiten des Rechteckhohlleiters (30) erfolgen.

**19.** Vorrichtung nach einem der Ansprüche 13 bis 18, dadurch gekennzeichnet, daß die Reaktionskammer (50) in einen Zylinderresonator (36) eingebaut ist und daß die Gaszuführung und Gasabsaugung durch die Zylinderböden (37,38) erfolgt, die durch die Kopfplatten (12a, 12b) gebildet werden.

**20.** Vorrichtung nach Anspruch 19, dadurch gekennzeichnet, daß die Einkopplung der Mikrowellen in den Zylinderresonator (36) aus einem umlaufenden Rechteckhohlleiter (30) über Schlitzkopplung oder Drahtschleifenkopplung erfolgt.

**21.** Vorrichtung nach einem der Ansprüche 19 oder 20, dadurch gekennzeichnet, daß die Einkopplung der Mikrowelle in den Zylinderresonator (36) mittels einer Lisitano-Spule (35) erfolgt.

**22.** Vorrichtung nach einem der Ansprüche 13 bis 21, dadurch gekennzeichnet, daß das zu beschichtende Substrat (1) zwischen der Vakuumkammer (14) und der Reaktionskammer (50) in der Substrathalterung (5) angeordnet ist, wobei die Vakuumkammer (40) an der Rückseite des Substrates angrenzt. deren Druck so niedrig eingestellt ist, daß kein Plasma zünden kann.

**23.** Vorrichtung nach einem der Ansprüche 13 his 22, dadurch gekennzeichnet, daß die Substrathalterung (5) im Zentrum der Reaktionskammer (50) angeordnet ist und
daß gegenüber den zu beschichtenden Oberflächen (2.3) des Substrates (1) jeweils eine Gaszonendusche (10a, b) angeordnet ist.

## Claims

**1.** Technique for determining process parameters for a PICVD method for producing coatings of uniform layer thickness on domed substrates, in particular on lenses made from glass or plastic, in which the substrate surface to be coated is arranged opposite the gas-pervious surface of a gas shower through which gas mixtures containing layer-forming gases flow into a reaction chamber where plasma impulses separated by temporal inter-impulse time periods are generated, characterized in that, while keeping constant the size of the gas-pervious surfaces and the gas mass flows through the gas-pervious surfaces, for a substrate type to be coated the inter-impulse time periods are varied in a first series of experiments in a stepwise fashion, proceeding from a starting value $t_A$, in one direction to determine an optimum value $t_{eff}$ until the layer thickness profiles respectively produced on the substrate exhibit no further convergence.

**2.** Technique according to Claim 1, characterized in that a gas zone shower is used as gas shower.

**3.** Technique according to Claim 2, characterized in that while largely retaining the value $t_{eff}$ for the inter-impulse time periods, the zone parameters of the gas zone shower, specifically the size of the gas-pervious surfaces and/or the gas mass flows through the zones, are varied in a stepwise fashion in a second series of experiments until the layer thickness profiles respectively produced on the substrates exhibit no further convergence.

4. Technique according to one of Claims 2 or 3, characterized in that use is made of a gas zone shower having a central circular and a middle as well as an outer annular zone.

5. Technique according to one of Claims 1 to 4, characterized in that a very long inter-impulse time period > 500 msec is set as starting value $t_A$.

6. Technique according to one of Claims 1 to 5, characterized in that the residual gas is pumped off over the edge of the gas zone shower.

7. Technique according to one of Claims 1 to 6, characterized in that the residual gas is pumped off in a rotationally symmetrical fashion relative to the substrate.

8. Technique according to one of Claims 1 to 7, characterized in that use is made of a microwave PICVD technique.

9. PICVD technique for producing coatings of uniform layer thickness on domed substrates, in particular on lenses made from glass or plastic, in which the substrate surface to be coated is arranged opposite the gas-permeable surface of a gas shower through which gas mixtures (fresh gas) containing layer-building gases flow into a reaction chamber where plasma impulses separated by temporal inter-impulse time periods are generated, characterized in that the coating is carried out with the aid of the process parameters determined in accordance with Patent Claim 1.

10. Technique according to Claim 9, characterized in that in the case of two surfaces of a substrate that are to be coated, the same are coated sequentially, the respectively free surface being located in a chamber in which the pressure is kept so low that no plasma can be generated.

11. Technique according to Claim 9, characterized in that in the case of two surfaces of a substrate that are to be coated, the same are coated simultaneously, a dedicated gas zone shower being arranged opposite each surface.

12. Technique according to one of Claims 9 to 11, characterized in that fresh gas is fed continuously to the reaction chamber.

13. Plasma CVD apparatus for producing coatings of uniform layer thickness on domed substrates such as lenses, in particular for spectacle lenses made from glass or plastic,

- having a reaction chamber in which there are arranged a substrate holder and at least one gas shower which is connected to a feed line for fresh gas which consists of the layer-forming gas, whose mass flow can be set via control devices, or a mixture of layer-forming gases, the reaction partner gas and, if appropriate, one or more inert gases, and
- having a microwave device for generating the plasma
- having a device for preventing undesired plasma treatment of the substrate surface not to be coated, and
- having a device for extracting the residual gases after a plasma ignition,

characterized in that

- the gas shower (10) is a planar gas-pervious surface (11) which is provided with holes for the passage of gas, which are arranged below the zone elements as gas distribution systems which define the zones (13, 14, 15) and/or can be varied via an adjusting device (55) and/or have at least one flexible wall, and/or in that a mask (59) with the prescribed hole pattern is provided between the gas zone shower (10) and substrate (1),
- the microwave device can be impulsed in the range from 0.1 to 500 ms, the inter-impulse time period being set in each case such that upon ignition of the next impulse a residual gas component of the preceding plasma impulse still remains in the reaction chamber,
- means are provided for maintaining an underpressure of < 0.1 Pa ($10^{-3}$ mb) on one side of the substrate holder with the substrate clamped in, or
- means are provided for simultaneously generating the plasma on both sides of the substrate holder with the substrate clamped in.

14. Apparatus according to Claim 13, characterized in that each feed line (17, 18) has a gas mass flow controller (25, 26).

15. Apparatus according to Claim 13 or 14, characterized in that the spacing between the gas zone shower (10) and the surface (2, 3) to be coated can be set.

16. Apparatus according to one of Claims 13 to 15, characterized in that the zones (13, 14, 15, 16) are arranged concentrically.

17. Apparatus according to one of Claims 13 to 16, characterized in that provided for the purpose of coating a convex or concave surface (2, 3) of a round substrate (1) having the diameter $D_v$ is a central zone (13) for feeding gas whose inside diameter $D_i$ is in the range from $0.1 \times D_v$ and $D_v$.

18. Apparatus according to one of Claims 13 to 17, characterized in that the reaction chamber (50) is built into a microwave rectangular waveguide (30), and in that the gas zone shower (10) is constructed in such a way that feeding the gas and extracting the gas are performed through the broad sides of the rectangular waveguide (30).

19. Apparatus according to one of Claims 13 to 18, characterized in that the reaction chamber (50) is built into a cylindrical resonator (36), and in that feeding the gas and extracting the gas are performed through the cylinder bases (37, 38) which are formed by the head plates (12a, 12b).

20. Apparatus according to Claim 19, characterized in that the microwaves are launched into the cylindrical resonator (36) from a circumferential rectangular waveguide (30) via a slot coupling or via loop coupling.

21. Apparatus according to one of Claims 19 or 20, characterized in that the microwaves are launched into the cylindrical resonator (36) by means of a Lisitano coil (35).

22. Apparatus according to one of Claims 13 to 21, characterized in that the substrate (1) to be coated is arranged between the vacuum chamber (14) and the reaction chamber (50) in the substrate holder (5), the vacuum chamber (40) bordering on the rear of the substrate, and its pressure being set so low that no plasma can ignite.

23. Apparatus according to one of Claims 13 to 22, characterized in that the substrate holder (5) is arranged at the centre of the reaction chamber (50) and in that a gas zone shower (10a, b) is arranged in each case opposite the surfaces (2, 3) of the substrate (1) that are to be coated.

**Revendications**

1. Procédé pour la détermination de paramètres de processus pour un procédé PICVD pour la réalisation de revêtements ayant une épaisseur de couche uniforme sur des substrats bombés, en particulier sur des lentilles en verre ou en matière synthétique, dans lequel la surface de substrat à revêtir est disposée en face de la face de sortie de gaz d'une douche à gaz, à travers laquelle des mélanges gazeux contenant des gaz filmogènes pénètrent dans une chambre de réaction, où sont produites des impulsions de plasma séparées par des pauses temporelles d'impulsion, caractérisé en ce que, pour un type de substrat à revêtir, on fait varier pas à pas, dans une première série d'essais, les pauses d'impulsion à partir d'une valeur initiale $t_A$ dans un sens visant à déterminer une valeur optimale $t_{eff}$, tout en maintenant constants la grandeur des faces de sortie de gaz et les flux massiques de gaz à travers les faces de sortie de gaz, jusqu'à ce que les profils d'épaisseur de couche respectivement produits sur les substrats ne révèlent aucune uniformisation supplémentaire.

2. Procédé suivant la revendication 1, caractérisé en ce que l'on utilise comme douche à gaz une douche à zones de gaz.

3. Procédé suivant la revendication 2, caractérisé en ce que, dans une deuxième série d'essais, on fait varier pas à pas les paramètres de zone de la douche à zones de gaz, à savoir la grandeur des faces de sortie de gaz et/ou les flux massiques de gaz à travers les zones, tout en conservant largement la valeur $t_{eff}$ pour les pauses d'impulsion, jusqu'à ce que les profils d'épaisseur de couche respectivement produits sur les substrats ne révèlent aucune uniformisation supplémentaire.

4. Procédé suivant l'une des revendications 2 ou 3, caractérisé en ce que l'on utilise une douche à zones de gaz avec une zone centrale circulaire et une zone moyenne ainsi qu'une zone extérieure annulaire.

5. Procédé suivant l'une quelconque des revendications 1 à 4, caractérisé en ce que l'on règle comme valeur initiale $t_A$ une très longue pause d'impulsion > 500 ms.

6. Procédé suivant l'une quelconque des revendications 1 à 5, caractérisé en ce que l'on aspire le gaz résiduel par le bord de la douche à zones de gaz.

7. Procédé suivant l'une quelconque des revendications 1 à 6, caractérisé en ce que l'on aspire le gaz résiduel avec une symétrie de rotation par rapport au substrat.

8. Procédé suivant l'une quelconque des revendications 1 à 7, caractérisé en ce que l'on utilise un procédé PICVD à micro-ondes.

9. Procédé PCVD pour la réalisation de revêtements ayant une épaisseur de couche uniforme sur des substrats bombés, en particulier sur des lentilles en verre ou en matière synthétique, dans lequel la surface de substrat à revêtir est disposée en face de la face de sortie de gaz d'une douche à gaz, à travers laquelle des mélanges gazeux (gaz frais) contenant des gaz filmogènes pénètrent dans une chambre de réaction, où sont produites des impulsions de plasma séparées par des pauses temporelles d'impulsion, caractérisé en ce que le revêtement est effectué avec les paramètres de processus déterminés conformément à la revendication 1.

10. Procédé suivant la revendication 9, caractérisé en ce que, dans le cas de deux surfaces d'un substrat à revêtir, celles-ci sont revêtues l'une après l'autre, la surface respectivement libre se trouvant dans une chambre, dans laquelle la pression est maintenue à un niveau si faible qu'aucun plasma ne peut être produit.

11. Procédé suivant la revendication 9, caractérisé en ce que, dans le cas de deux surfaces d'un substrat à revêtir, celles-ci sont revêtues simultanément, une douche à zones de gaz propre étant disposée en face de chaque surface.

12. Procédé suivant l'une quelconque des revendications 9 à 11, caractérisé en ce que l'on fournit du gaz frais en continu à la chambre de réaction.

13. Dispositif plasma-CVD pour la réalisation de revêtements ayant une épaisseur de couche uniforme sur des substrats bombés, tels que des lentilles, en particulier pour des verres de lunettes en verre ou en matière synthétique,

- avec une chambre de réaction, dans laquelle est disposé un support de substrat et au moins une douche à gaz, qui est raccordée à une conduite d'arrivée pour du gaz frais, qui se compose du gaz filmogène, dont le flux massique est réglable par des dispositifs de régulation, ou d'un mélange de gaz filmogènes, du gaz participant à la réaction et éventuellement d'un ou de plusieurs gaz inerte(s), et
- avec un dispositif à micro-ondes pour la production du plasma,
- avec un dispositif pour empêcher un traitement involontaire au plasma d'une surface de substrat qui n'est pas à revêtir, et
- avec un dispositif pour aspirer les gaz résiduels après l'amorçage d'un plasma,

    caractérisé en ce que

- la douche à gaz (10) est une face plane de sortie de gaz (11), qui est pourvue de trous pour le passage du gaz et sous laquelle sont disposés, au titre de systèmes de répartition du gaz, des éléments de zone qui définissent les zones (13, 14, 15) et/ou peuvent être modifiés par un dispositif de réglage (55) et/ou présentent au moins une paroi flexible, et/ou en ce qu'il est prévu un masque (59) avec un motif perforé prédéterminé entre la douche à zones de gaz (10) et le substrat (1),
- le dispositif à micro-ondes peut être pulsé dans le domaine de 0,1 à 500 ms, la pause d'impulsion étant réglée respectivement de telle façon qu'à l'amorçage de l'impulsion suivante, il subsiste encore dans la chambre de réaction une fraction de gaz résiduel de l'impulsion de plasma précédente,
- il est prévu des moyens pour maintenir une dépression de < 0,1 Pa ($10^{-3}$ mb) sur un côté du support de substrat avec le substrat monté,

ou

- il est prévu des moyens pour produire simultanément le plasma sur les deux côtés du support de substrat avec le substrat monté.

**14.** Dispositif suivant la revendication 13, caractérisé en ce que chaque conduite d'arrivée (17, 18) présente un régulateur du flux massique de gaz (25, 26).

**15.** Dispositif suivant la revendication 13 ou 14, caractérisé en ce que la distance entre la douche à zones de gaz (10) et la surface à revêtir (2, 3) est réglable.

**16.** Dispositif suivant l'une quelconque des revendications 13 à 15, caractérisé en ce que les zones (13, 14, 15, 16) sont disposées de façon concentrique.

**17.** Dispositif suivant l'une quelconque des revendications 13 à 16, caractérisé en ce qu'il est prévu, pour le revêtement d'une surface convexe ou concave (2, 3) d'un substrat rond (1) avec le diamètre $D_v$, une zone centrale (13) pour l'arrivée de gaz, dont le diamètre intérieur $D_i$ se situe dans le domaine de $0,1 \times D_v$ à $D_v$.

**18.** Dispositif suivant l'une quelconque des revendications 13 à 17, caractérisé en ce que la chambre de réaction (50) est incorporée dans un conducteur creux rectangulaire à micro-ondes (30) et en ce que la douche à zones de gaz (10) est configurée de telle façon que l'arrivée de gaz et l'aspiration de gaz se fassent par les côtés larges du conducteur creux rectangulaire (30).

**19.** Dispositif suivant l'une quelconque des revendications 13 à 18, caractérisé en ce que la chambre de réaction (50) est incorporée dans un résonateur cylindrique (36) et en ce que l'arrivée de gaz et l'aspiration de gaz se font à travers les fonds (37, 38) du cylindre, qui sont formés par les plaques de tête (12a, 12b).

**20.** Dispositif suivant la revendication 19, caractérisé en ce que le couplage des micro-ondes dans le résonateur cylindrique (36) à partir d'un conducteur creux rectangulaire enveloppant (30) est réalisé par couplage par fentes ou par couplage par boucle de fil.

**21.** Dispositif suivant l'une des revendications 19 ou 20, caractérisé en ce que le couplage des micro-ondes dans le résonateur cylindrique (36) est réalisé au moyen d'une bobine de Lisitano (35).

**22.** Dispositif suivant l'une quelconque des revendications 13 à 21, caractérisé en ce que le substrat à revêtir (1) est disposé entre la chambre à vide (14) et la chambre de réaction (50) dans le support de substrat (5), la chambre à vide (40) étant jointive au dos du substrat, la pression de celle-ci étant réglée à un niveau si bas qu'aucun plasma ne peut s'amorcer.

**23.** Dispositif suivant l'une quelconque des revendications 13 à 22, caractérisé en ce que le support de substrat (5) est disposé au centre de la chambre de réaction (50) et en ce qu'une douche à zones de gaz (10a, b) est respectivement disposée en face des surfaces à revêtir (2, 3) du substrat (1).

Fig. 1

Fig. 2,

Fig. 3

Fig. 4

Fig. 5

Fig. 6

a.

b.

Fig. 7

Fig. 8

* Winkel = Winkel zwischen der optischen Achse der Linse und einer Position auf der Linse, vom Brennpunkt aus gemessen

Fig. 9

EP 0 753 082 B1

Fig. 10

Fig. 11

EP 0 753 082 B1

Fig. 12

Fig. 13

EP 0 753 082 B1

Fig. 14

Fig. 15

EP 0 753 082 B1